# EUROPEAN PATENT APPLICATION

(11) **EP 4 806 932 A1**
(43) Date of publication of application: **16.09.2026**
(21) Application number: 24888381.1
(22) Date of filing: 09.09.2024
(51) Int. Cl.: C08G 59/40, C08K 3/013, C08K 5/5415, C08L 63/00, H05K 1/03

(54) **COMPOSITION, EPOXY RESIN COMPOSITION, FILM, PRINTED WIRING BOARD, SEMICONDUCTOR CHIP PACKAGE, AND ELECTRONIC DEVICE**

(30) Priority: 06.11.2023 JP 2023189603
(71) Applicant: ASAHI KASEI KABUSHIKI KAISHA, Tokyo 100-0006 (JP)
(72) Inventor: YOSHIDA, Masanori, Tokyo 100-0006 (JP); KOBAYASHI, Naohiro, Tokyo 100-0006 (JP)
(74) Representative: Hoffmann Eitle
(86) International application number: PCT/JP2024/032222
(87) International publication number: WO 2025/100081

(57) **Abstract**

Provided is a composition comprising
(b): a compound represented by the following formula (1), and
(c): a compound represented by the following formula (2) (except for the compound represented by the formula (1)): 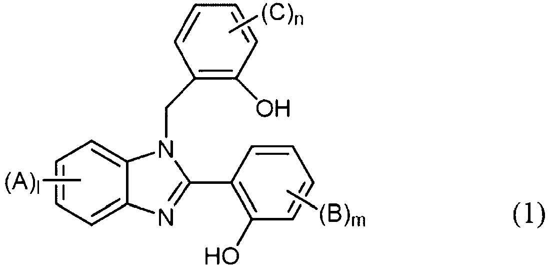 wherein each of A, B, and C is a hydrogen atom, a halogen atom, a hydroxy group, a carboxy group, a cyano group, a nitro group, an alkyl group having 1 to 20 carbon atoms and optionally having a substituent, or the like; and each of I, m, and n is an integer of 1 to 4, 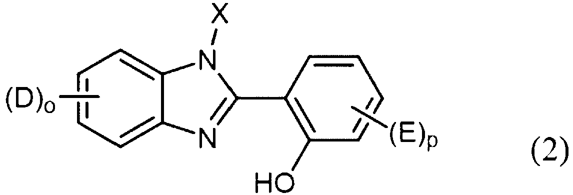 wherein X is a hydrogen atom, an alkyl group having 1 to 20 carbon atoms and optionally having a substituent, or the like; each of D and E is a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, or the like, and two or more D moieties or two or more E moieties are optionally bonded to each other to form a monocyclic ring or a condensed ring; and each of o and p is an integer of 1 to 4.

## Description

### Technical Field

The present invention relates to a composition, an epoxy resin composition, a film, a printed wiring board, a semiconductor chip package, and an electronic device.

### Background Art

Epoxy resins have heretofore been utilized for a wide range of purposes such as insulating materials, sealing materials, adhesives, and conductive materials for electric and electronic components including semiconductor devices, matrix resins for fiber-reinforced plastics, and impregnant fixatives for motor coils.

Among others, epoxy resin compositions which are excellent in adhesion and exhibit high reliability are used in adhesives for semiconductor devices or adhesives for printed wiring boards. An epoxy resin, a curing agent having reactivity with the epoxy resin, and other components such as a filler are generally used as components constituting the epoxy resin compositions.

With recent increase in performance of electronic devices, electronic circuit substrate materials for printed wiring boards and the like employ a buildup layer and are multilayered and required to have a lower dielectric dissipation factor for reducing loss of transmission, and reduction in warpage of substrates with advances in finer wiring and a higher density.

For the packaging of semiconductor chips using the epoxy resin compositions, wafer-level packages or panel-level packages have received attention in order to achieve high productivity or cost reduction. Such packages are also required to have reduction in warpage, for applying the epoxy resin compositions to large substrates and curing the epoxy resin compositions.

As for epoxy resin compositions as insulating resin materials to be applied to wafer-level packages or printed wiring boards, an insulating resin material has heretofore been disclosed which contains, for example, a thermosetting resin, an inorganic filler, and a polymer resin having a glass transition temperature of 30°C or lower, having one or more skeletons selected from a butadiene skeleton, a carbonate skeleton, an acrylic skeleton, and a siloxane skeleton, and further having one or more skeletons selected from an amide skeleton, an imide skeleton, and a urethane skeleton (see, for example, Patent Document 1).

### List of Prior Art Documents

### Patent Document

Patent Document 1: Japanese Patent Laid-Open No. 2021-95580

### Summary of Invention

### Problems to be Solved by Invention

Along with the multilayering of buildup layers in electronic circuit substrate materials or the popularization of wafer-level packages or panel-level packages in semiconductor chips, epoxy resin compositions are required to be capable of further suppressing the warpage of substrates. Also, cured products of epoxy resin compositions are required to have excellent mechanical strength and high adhesion strength to finer and higher-density wiring.

However, the epoxy resin composition disclosed in Patent Document 1 presents the problem that the epoxy resin composition is still susceptible to improvement in various requirements for epoxy resin compositions as mentioned above.

Accordingly, an object of the present invention is to provide, in light of the problems of the conventional techniques mentioned above, a composition from which an epoxy resin composition can be obtained that causes little warpage of a base material (including various substrates; hereinafter, also simply referred to as a base material) having a cured product of the epoxy resin composition and is excellent in strength of the cured product and adhesion strength to a metal adherend.

### Means for Solving Problems

The present inventor has conducted diligent studies and consequently completed the present invention by finding that an epoxy resin composition that causes little warpage of a base material having a cured product and is excellent in strength of the cured product and adhesion strength to a metal adherend can be obtained by using a composition containing a compound having a specific structure.

Specifically, the present invention is as follows.

[1] A composition comprising
   (b): a compound represented by the following formula (1), and
   (c): a compound represented by the following formula (2) (except for the compound represented by the formula (1)): 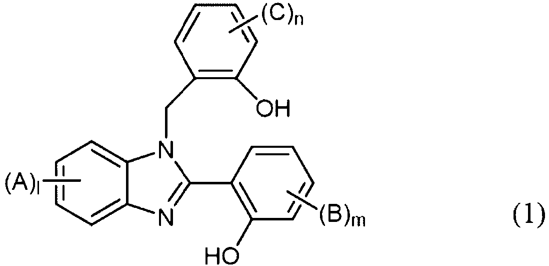 wherein
      each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4,

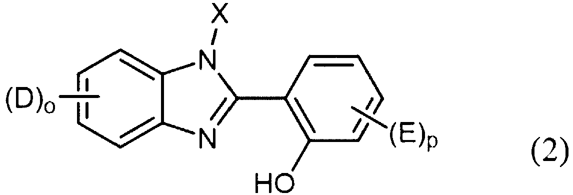

         wherein
      X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
      each of D and E is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, D and E are the same as or different from each other, and two or more D moieties or two or more E moieties are optionally bonded to each other to form a monocyclic ring or a condensed ring; and
      each of o and p is an integer of 1 to 4.
[2] The composition according to [1], wherein the composition is a curing agent.
[3] The composition according to [1] or [2], wherein
   a mass ratio between (b): the compound represented by the formula (1) and (c): the compound represented by the formula (2) (except for the compound represented by the formula (1)) is (b):(c) = 0.001:100 to 20:80.
[4] The composition according to any one of [1] to [3], wherein the composition is an adhesion promoter.
[5] The composition according to any one of [1] to [4], wherein
   in (b): the compound represented by the formula (1),
   each of A, B, and C is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.
[6] The composition according to any one of [1] to [5], wherein
   in (c): the compound represented by the formula (2),
   X is a hydrogen atom, and each of D and E is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.
[7] The composition according to any one of [1] to [6], comprising,
   as (b): the compound represented by the formula (1),
   any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol.
[8] The composition according to any one of [1] to [7], comprising,
   as (c): the compound represented by the formula (2),
   any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid.
[9] An epoxy resin composition comprising
   the composition according to any one of [1] to [8], and
   (a): an epoxy resin.
[10] An epoxy resin composition comprising
   (b): a compound represented by the formula (1), and
   (a): an epoxy resin: 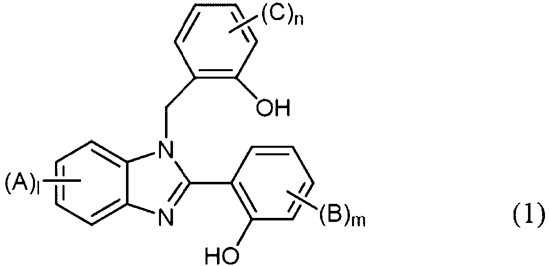
   wherein
   each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4.
[11] An epoxy resin composition comprising
   the composition according to [7], and
   (a): an epoxy resin.
[12] The epoxy resin composition according to any one of [9] to [11], further comprising
   (d): a filler.
[13] The epoxy resin composition according to any one of [9] to [12], further comprising
   (e): at least one member selected from the group consisting of a phenol compound, an active ester compound, and a cyanate ester compound.
[14] The epoxy resin composition according to any one of [9] to [13], further comprising
   (f): a polymer (except for the component (a) and the component (e)).
[15] The epoxy resin composition according to any one of [9] to [14], further comprising
   (g): a silane coupling agent.
[16] The epoxy resin composition according to any one of [9] to [15], comprising
   as (b): the compound represented by the formula (1),
   any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol, and
   as (c): the compound represented by the formula (2),
   any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid, wherein
   a mass ratio between the component (b) and the component (c) is (b):(c) = 0.001:100 to 20:80, and
   further comprising
   (d): a filler,
   (e): at least one member selected from the group consisting of a phenol compound, an active ester compound, and a cyanate ester compound,
   (f): a polymer (except for the component (a) and the component (e)), and (g): a silane coupling agent.
[17] A film having
   a support, and
   a resin layer comprising the epoxy resin composition according to any one of [9] to [16] on the support.
[18] A printed wiring board having
   a cured product layer of the epoxy resin composition according to any one of [9] to [16].
[19] A semiconductor chip package having
   a cured product layer of the epoxy resin composition according to any one of [9] to [16].
[20] An electronic device having the printed wiring board according to [18].
[21] An electronic device having the semiconductor chip package according to [19].

### Advantages of Invention

The present invention can provide a composition from which an epoxy resin composition can be obtained that causes little warpage of a base material having a cured product of the epoxy resin composition and is excellent in strength of the cured product and adhesion strength to a metal adherend.

### Mode for Carrying Out Invention

Hereinafter, the mode for carrying out the present invention (hereinafter, referred to as the "present embodiment") will be described in detail.

The present embodiment described below is given for illustrating the present invention and does not intend to limit the present invention to the contents given below. The present invention can be carried out through appropriate changes or modifications made without departing from the spirit of the present invention.

### [composition]

The composition of the present embodiment comprises
(b): a compound represented by the following formula (1), and
(c): a compound represented by the following formula (2) (except for the compound represented by the formula (1)): 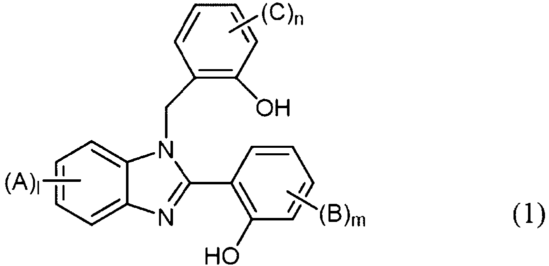 wherein
   each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4, 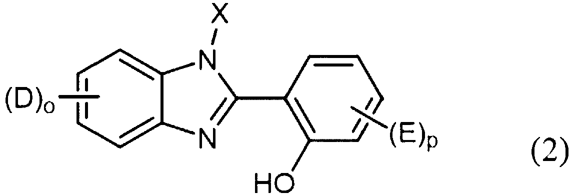 wherein
   X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent.

Each of D and E is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, D and E are the same as or different from each other, and two or more D moieties or two or more E moieties are optionally bonded to each other to form a monocyclic ring or a condensed ring.

Each of o and p is an integer of 1 to 4.

The composition of the present embodiment thus configured can be used as a curing agent for an epoxy resin composition mentioned later and can be combined with (a) an epoxy resin mentioned later to obtain an epoxy resin composition that tends to cause little warpage (hereinafter, also referred to as low warpage) of a base material having a cured product of the epoxy resin composition and is excellent in strength of the cured product and adhesion strength to a metal adherend.

### (Component (b):compound represented by formula (1))

The composition of the present embodiment comprises (b): a compound represented by the formula (1) given below (hereinafter, also referred to as a component (b)).

The component (b) functions as a curing agent in an epoxy resin composition containing (a) an epoxy resin mentioned later in combination therewith, and is also capable of functioning as a curing accelerator when a curing agent is separately blended therewith.

One of such components (b) may be used singly, or two or more thereof may be used in combination.

The epoxy resin composition of the present embodiment mentioned later comprises the component (b) and thereby tends to be excellent in strength of a cured product and adhesion to a metal adherend. Furthermore, the epoxy resin composition tends to be excellent in film preservation stability when prepared into a film.

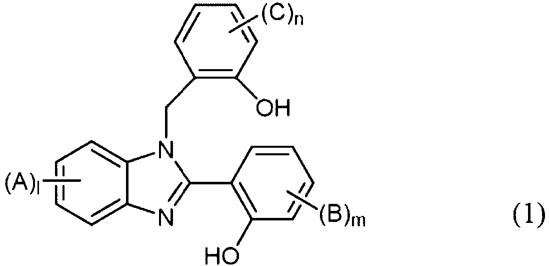

In the formula (1), each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4.

The alkyl group having 1 to 20 carbon atoms as A, B, or C may be linear or branched, and the number of carbon atoms in the alkyl group is preferably 1 to 18, more preferably 1 to 15. Examples of the alkyl group having 1 to 20 carbon atoms include a methyl group, an ethyl group, a propyl group, an isopropyl group, a butyl group, an isobutyl group, a hexyl group, an octyl group, a 2-ethylhexyl group, a decyl group, and an undecyl group.

The alkoxy group having 1 to 20 carbon atoms as A, B, or C may be linear or branched, and the number of carbon atoms is preferably 1 to 18, more preferably 1 to 15. Examples of the alkoxy group having 1 to 20 carbon atoms include a methoxy group, an ethoxy group, a propoxy group, an isopropoxy group, a butoxy group, a hexyloxy group, and a 2-ethylhexyloxy group.

The alkenyl group having 2 to 20 carbon atoms as A, B, and C may be linear or branched, and the number of carbon atoms in the alkenyl group is preferably 2 to 18, more preferably 2 to 15. Examples of the alkenyl group having 2 to 20 carbon atoms include a vinyl group, an allyl group, a 1-propenyl group, an isopropenyl group, a 2-butenyl group, a 3-butenyl group, a 2-pentenyl group, and a 2-hexenyl group.

The number of carbon atoms in the aryl group having 6 to 20 carbon atoms as A, B, or C is preferably 6 to 18, more preferably 6 to 15. Examples of the aryl group having 6 to 20 carbon atoms include a phenyl group, a naphthyl group, an anthracenyl group, and a biphenyl group.

The number of carbon atoms in the acyl group having 1 to 20 carbon atoms as A, B, or C is preferably 1 to 18, more preferably 1 to 15. Examples of the acyl group having 1 to 20 carbon atoms include an acetyl group, a benzoyl group, and a pivaloyl group.

Examples of the structure where two or more A moieties, two or more B moieties, or two or more C moieties are bonded to each other to form a monocyclic ring or a condensed ring include a naphthyl group and an anthracenyl group.

The alkyl group, the alkoxy group, the alkenyl group, the aryl group, the aryloxy group, and the acyl group may each have a substituent. Examples of the substituent include an alkyl group, a halogen group, a hydroxy group, a carboxy group, an alkoxy group, a nitro group, an ester group, and a phenyl group. The substituent is preferably an alkyl group, a hydroxy group, a carboxy group, or an alkoxy group.

The mechanism under which the component (b) imparts excellent cured product strength to the epoxy resin composition of the present embodiment mentioned later is presumably, but not intended to be limited to, as follows.

The component (b) has two phenolic hydroxy groups and has an imidazole ring and therefore has a high probability of being incorporated into a cross-linked structure at the time of curing of (a) an epoxy resin mentioned later while being able to increase the molecular weight of a formed molecular chain. Also, the component (b) can contribute to improvement in density of cross-links. From these viewpoints, the component (b) can impart excellent cured product strength to the epoxy resin composition of the present embodiment mentioned later.

The mechanism under which the component (b) imparts excellent adhesion to a metal adherend to the epoxy resin composition of the present embodiment mentioned later is presumably, but not intended to be limited to, as follows.

The component (b) has an imidazole ring and a hydroxyl group and is therefore excellent in coordination bondability of these functional groups to metal surface while enabling a molecular chain structurally containing the component (b) formed at the time of curing of (a) an epoxy resin to be coordination-bonded to a metal adherend, thereby imparting excellent adhesion thereto.

As also described in the mechanism under which film preservation stability mentioned later is imparted thereto, the epoxy resin composition of the present embodiment mentioned later comprises both the component (b) and the component (c) and thereby exerts excellent stability. The epoxy resin composition can thereby be sufficiently wet-spread over the asperities of a metal base material at the time of heat curing of the epoxy resin composition and can secure a sufficient adhesion area and anchoring effect. Therefore, excellent adhesion to a metal adherend can be imparted thereto.

When the epoxy resin composition of the present embodiment mentioned later is prepared into a film for adhesion, the film of the epoxy resin composition is melted by heating and laminated with a metal base material. In this respect, because of excellent stability, the film can achieve sufficient reduction in viscosity and can sufficiently follow the asperities of the metal base material and can therefore secure a sufficient adhesion surface area and anchoring effect. Therefore, excellent adhesion strength can be imparted thereto.

The mechanism under which the component (b) imparts excellent preservation stability to a film made of the epoxy resin composition of the present embodiment mentioned later is presumably, but not intended to be limited to, as follows.

The component (b) can function as a curing agent and is stabilized with its nucleophilicity suppressed because a nitrogen atom at position 3 of an imidazole ring and a hydroxy group of its adjacent hydroxyphenyl group form a hydrogen bond under conditions of film storage temperatures, specifically, under a frozen or refrigerated low-temperature condition and further at room temperature on the order of 25 to 40°C for film storage. Furthermore, reactivity is suppressed because a nitrogen atom at position 1 of an imidazole ring is also substituted by a bulky hydroxybenzyl group. When the epoxy resin composition of the present embodiment mentioned later has both the component (c) mentioned later and the component (b), the component (c) and the component (b) having similar structures easily get closer to each other in the epoxy resin composition and exert intermolecular interaction that forms the hydrogen bond of a nitrogen atom on an imidazole ring to a hydroxyphenyl group between molecules. The reactivity of both the component (b) and the component (c) can thereby be suppressed. On the other hand, an intramolecular or intermolecular hydrogen bond that contributes to the suppression of reaction described above is dissociated under heat curing conditions, thereby exerting sufficient reactivity.

In the component (b): the compound represented by the formula (1), each of A, B, and C is preferably one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

Each of A, B, and C is a hydrogen atom, whereby a cured product obtained using the epoxy resin composition of the present embodiment mentioned later can have a lower dielectric dissipation factor.

When each of A, B, and C is a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, or an acyl group having 1 to 20 carbon atoms and having a hydroxy group and/or a carboxy group as a substituent, coordination bondability to an adherend such as a metal is increased: thus, close contact and adhesion strength tend to be able to be improved in the epoxy resin composition mentioned later.

It is more preferred to comprise, as the component (b): the compound represented by the formula (1), any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, 3-[[2-(2,3-dihydroxyphenyl)-1H-benzimidazol-1-yl]methyl]-1,2-benzenediol. It is further preferred to comprise 2-[[2-(2-hydroxyphenyl)-1H-benzimidazol-1-yl]methyl]phenol from the viewpoint of coordination bondability to a metal adherend ascribable to small steric hindrance, and the intermolecular hydrogen bond formability of the component (c) mentioned later and the component (b).

The structure of 2-[[2-(2-hydroxyphenyl)-1H-benzimidazol-1-yl]methyl]phenol is represented by the following formula (I):

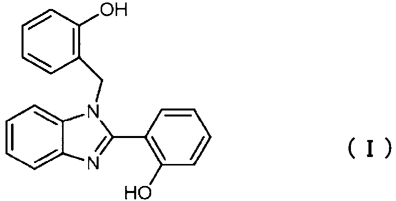

The content of the component (b) in an epoxy resin composition comprising the composition of the present embodiment combined with (a) an epoxy resin mentioned later can be appropriately set depending on desired performance and is not particularly limited. The content is preferably 0.00001% by mass or more, more preferably 0.0001% by mass or more, further preferably 0.001% by mass or more, still further preferably 0.01% by mass or more, even further preferably 0.03% by mass or more, in all involatile components except for a solvent from the viewpoint of exerting excellent cured product strength, adhesion to a metal adherend, and film preservation stability in the form of a film.

The content of the component (b) is preferably 5% by mass or less, more preferably 2% by mass or less, further preferably 1% by mass or less, still further preferably 0.5% by mass or less, even further preferably 0.1% by mass or less, in all involatile components except for a solvent from the viewpoint of the preservation stability of a film obtained using the epoxy resin composition.

As for a method for adding the component (b) for an epoxy resin composition comprising the composition of the present embodiment combined with (a) an epoxy resin mentioned later, the component (b) may be added when mixed with other components or may be formed in a system after mixing of other components. Alternatively, the component (b) may be formed and added in producing component (a): an epoxy resin mentioned later, the component (c) to a component (g) mentioned later, and other predetermined additives.

A feature of the epoxy resin composition of the present embodiment mentioned later is that the component (b) is used as an essential constituent discriminated from the component (c) mentioned later. The resulting epoxy resin composition is excellent in cured product strength and preservation stability.

### (Component (c): compound represented by formula (2))

The composition of the present embodiment comprises a compound represented by the formula (2) given below (hereinafter, also referred to as a component (c)).

(c): the compound represented by the formula (2) excludes the compound represented by the formula (1). In other words, the component (c) and the component (b) are different compounds.

The component (c) can function as a curing agent in the epoxy resin composition of the present embodiment mentioned later, and is also capable of functioning as a curing accelerator when a curing agent is separately blended therewith.

On the other hand, the epoxy resin composition mentioned later comprises the component (c) and thereby tends to be excellent in low warpage of a base material having a cured product thereof.

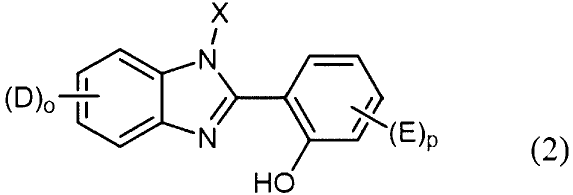

In the formula (2), X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
each of D and E is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, D and E are the same as or different from each other, and two or more D moieties or two or more E moieties are optionally bonded to each other to form a monocyclic ring or a condensed ring; and each of o and p is an integer of 1 to 4.

In the formula (2), the alkenyl group having 2 to 20 carbon atoms as X may be linear or branched, and the number of carbon atoms in the alkenyl group is preferably 2 to 18, more preferably 2 to 15. Examples of the alkenyl group having 2 to 20 carbon atoms include a vinyl group, an aryl group, a 1-propenyl group, an isopropenyl group, a 2-butenyl group, a 3-butenyl group, a 2-pentenyl group, and a 2-hexenyl group.

The aralkyl group having 7 to 20 carbon atoms as X may be linear or branched, and the number of carbon atoms in the aralkyl group is preferably 7 to 18, more preferably 7 to 15. Examples of the aralkyl group having 7 to 20 carbon atoms include a benzyl group, a phenethyl group, and a naphthylmethyl group.

The heteroarylalkyl group having 4 to 20 carbon atoms as X may be linear or branched, and the number of carbon atoms in the heteroarylalkyl group is preferably 4 to 18, more preferably 4 to 15. Examples of the heteroarylalkyl group having 4 to 20 carbon atoms include a triazinylmethyl group, a triazinylethyl group, a 2-pyridylmethyl group, a 2-pyridylethyl group, a 3-pyridylmethyl group, a 3-pyridylethyl group, a 4-pyridylmethyl group, and a 4-pyridylethyl group.

The alkyl group, the alkenyl group, the aralkyl group, or the heteroarylalkyl group may have a substituent. Examples of the substituent include a halogen group, a cyano group, a nitro group, a hydroxy group, an alkoxy group, an amino group, an ester group, an arylsulfonyl group, an alkylsulfonyl group, and a phenyl group. The substituent is preferably a cyano group, an alkoxy group, an amino group, an ester group, or a phenyl group.

The alkyl group having 1 to 20 carbon atoms as D or E may be linear or branched, and the number of carbon atoms in the alkyl group is preferably 1 to 18, more preferably 1 to 15. Examples of the alkyl group having 1 to 20 carbon atoms include a methyl group, an ethyl group, a propyl group, an isopropyl group, a butyl group, an isobutyl group, a hexyl group, an octyl group, a 2-ethylhexyl group, a decyl group, and an undecyl group.

The alkoxy group having 1 to 20 carbon atoms as D or E may be linear or branched, and the number of carbon atoms is preferably 1 to 18, more preferably 1 to 15. Examples of the alkoxy group having 1 to 20 carbon atoms include a methoxy group, an ethoxy group, a propoxy group, an isopropoxy group, a butoxy group, a hexyloxy group, and a 2-ethylhexyloxy group.

The alkenyl group having 2 to 20 carbon atoms as D or E may be linear or branched, and the number of carbon atoms in the alkenyl group is preferably 2 to 18, more preferably 2 to 15. Examples of the alkenyl group having 2 to 20 carbon atoms include a vinyl group, an aryl group, a 1-propenyl group, an isopropenyl group, a 2-butenyl group, a 3-butenyl group, a 2-pentenyl group, and a 2-hexenyl group.

The number of carbon atoms in the aryl group having 6 to 20 carbon atoms as D or E is preferably 6 to 18, more preferably 6 to 15. Examples of the aryl group having 6 to 20 carbon atoms include a phenyl group, a naphthyl group, an anthracenyl group, and a biphenyl group.

The number of carbon atoms in the acyl group having 1 to 20 carbon atoms as D or E is preferably 1 to 18, more preferably 1 to 15. Examples of the acyl group having 1 to 20 carbon atoms include an acetyl group, a benzoyl group, and a pivaloyl group.

Examples of the structure where two or more D moieties or two or more E moieties are bonded to each other to form a monocyclic ring or a condensed ring include a naphthyl group and an anthracenyl group.

The alkyl group, the alkoxy group, the alkenyl group, the aryl group, the aryloxy group, and the acyl group may each have a substituent. Examples of the substituent include an alkyl group, a halogen atom, a hydroxy group, a carboxy group, an alkoxy group, a nitro group, an ester group, and a phenyl group. The substituent is preferably an alkyl group, a hydroxy group, a carboxy group, or an alkoxy group.

Examples of the component (c) include, but are not limited to, the following imidazole compounds: 2-(2-hydroxyphenyl)benzimidazole, 2-(2-hydroxy-3-methylphenyl)benzimidazole, 2-(2-hydroxy-4-methylphenyl)benzimidazole, 2-(2-hydroxy-5-methylphenyl)benzimidazole, 2-(3-T-butyl-2-hydroxyphenyl)benzimidazole, 2-(4-fluoro-2-hydroxyphenyl)benzimidazole, 2-(4-chloro-2-hydroxyphenyl)benzimidazole, 2-(4-bromo-2-hydroxyphenyl)benzimidazole, 2-(2,3-dihydroxyphenyl)benzimidazole, 2-(2,5-dihydroxyphenyl)benzimidazole, 2-(2-hydroxy-4-methoxyphenyl)benzimidazole, 2-(2-hydroxy-3-methoxyphenyl)benzimidazole, 2-(2-hydroxy-5-methoxyphenyl)benzimidazole, 2-(2-hydroxy-6-methoxyphenyl)benzimidazole, 2-(3-ethoxy-2-hydroxyphenyl)benzimidazole, 2-(5-ethoxy-2-hydroxyphenyl)benzimidazole, 2-(4-allyl-2-hydroxy-3-methoxyphenyl)benzimidazole, 2-(4,6-dimethoxy-2-hydroxyphenyl)benzimidazole, 2-(5-fluoro-2-hydroxyphenyl)benzimidazole, 2-(5-chloro-2-hydroxyphenyl)benzimidazole, 2-(5-bromo-2-hydroxyphenyl)benzimidazole, 2-(6-fluoro-2-hydroxy-3-methoxyphenyl)benzimidazole, 2-(1-hydroxynaphthalen-2-yl)benzimidazole, and 2-(2-hydroxynaphthalen-1-yl)benzimidazole, 2-(2-hydroxyphenyl)benzimidazole-6-carboxylic acid.

One of these components (c) may be used singly, or two or more thereof may be used in combination.

The mechanism under which the component (c): the compound represented by the formula (2) imparts excellent low warpage to the epoxy resin composition of the present embodiment mentioned later is presumably, but not intended to be limited to, as follows.

The component (C) plays a role as a chain transfer agent derived from its structural feature such that a proton for stabilization is donated to an anion formed in ring opening through the reaction of an epoxy group with imidazole, by a hydroxyphenyl group located close thereto. This suppresses uneven acute formation of high-molecular-weight products and local thickening in the neighborhood of the reactive site during polymerization reaction and can cause chain extension reaction throughout the system. Thus, thickening during curing occurs mildly and uniformly so that stress generated during curing tends to be easily relaxed to reduce warpage in a base material having a cured product of the epoxy resin composition.

The mechanism mentioned above is a mechanism that is generated between an epoxy resin (a) and the component (c) and is therefore applicable to an epoxy resin composition further comprising an additional curing agent component such as a phenol-based curing agent, an active ester-based curing agent, or a cyanate ester-based curing agent.

In the component (c): the compound represented by the formula (2), preferably, X is a hydrogen atom, and each of D and E is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

X is hydrogen, whereby better reactivity can be obtained.

Each of D and E is a hydrogen atom, whereby a cured product obtained using the epoxy resin composition of the present embodiment tends to be able to have a lower dielectric dissipation factor.

When each of D and E is any one member selected from the group consisting of a hydroxy group, a carboxy group, an alkoxy group having 1 to 20 carbon atoms and having no substituent, an alkyl group having 1 to 20 carbon atoms and having a hydroxy group and/or a carboxy group as a substituent, an alkoxy group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent, coordination bondability to an adherend such as a metal is increased: thus, close contact and adhesion strength tend to be able to be improved.

The component (c): the compound represented by the formula (2) is preferably 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, or 2-(2-hydroxyphenyl)benzimidazole-6-carboxylic acid, more preferably 2-(2-hydroxyphenyl)benzimidazole from the viewpoint of the achievement of reactivity and stability, the exertion of low warpage, and intermolecular interaction formability with the component (b).

The content of the component (c) in the epoxy resin composition of the present embodiment mentioned later is not particularly limited and is preferably 0.005% by mass or more, more preferably 0.05% by mass or more, further preferably 0.1% by mass or more, still further preferably 0.15% by mass or more, even further preferably 0.2% by mass or more, in all involatile components except for a solvent from the viewpoint of obtaining sufficient curability. The content of the component (c) is preferably 10% by mass or less, more preferably 5% by mass or less, further preferably 4% by mass or less, still further preferably 3% by mass or less, even further preferably 2% by mass or less, in all involatile components except for a solvent from the viewpoint of keeping a curing rate proper and maintaining a uniform cured layer.

The component (c) may be added when mixed with other components or may be formed in a system after mixing of other components. Alternatively, the component (c) may be formed and added in producing a component (a) mentioned later, the component (b) mentioned above, a component (d) to a component (g) mentioned later, and additives.

### (Mass ratio between component (b) and component (c))

In the composition of the present embodiment, the mass ratio between the component (b) and the component (c) is preferably (b):(c) = 0.001:100 to 20:80, more preferably 0.01:100 to 15:85, more preferably 0.1:100 to 10:90, further preferably 1:100 to 8:92, from the viewpoint of excellently achieving reactivity and preservation stability.

The component (c) is a highly crystalline compound and may remain in a crystal form in the epoxy resin composition of the present embodiment mentioned later. The component (b) structurally similar to and capable of interacting with the component (c) is contained even in a very small amount and thereby improves the component (c) remaining in a crystal form as mentioned above so that the composition of the present embodiment exhibits excellent reactivity. Thus, the epoxy resin composition of the present embodiment mentioned later tends to exert favorable cured product strength and adhesion.

### [Epoxy resin composition]

The epoxy resin composition of the present embodiment comprises (a): an epoxy resin (hereinafter, also referred to as an epoxy resin (a) or a component (a)) and (b): the compound represented by the formula (1) mentioned above.

A preferred form of the epoxy resin composition of the present embodiment comprises the epoxy resin (a) and the composition of the present embodiment mentioned above.

The epoxy resin composition of the present embodiment more preferably comprises, as the component (b): the compound represented by the formula (1), any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol from the viewpoint of the strength of a cured product and adhesion to a metal adherend.

### (Component (a): epoxy resin)

The epoxy resin composition of the present embodiment contains (a): an epoxy resin (hereinafter, also referred to as an epoxy resin (a) or a component (a)).

Examples of the epoxy resin (a) for use in the epoxy resin composition of the present embodiment include, but are not limited to, bifunctional epoxy resins such as bisphenol A-type epoxy resin, bisphenol F-type epoxy resin, bisphenol E-type epoxy resin, bisphenol AD-type epoxy resin, bisphenol AF-type epoxy resin, tetrabromobisphenol A-type epoxy resin, biphenyl-type epoxy resin, bixylenol-type epoxy resin, tetrabromobiphenyl-type epoxy resin, diphenyl ether-type epoxy resin, benzophenone-type epoxy resin, phenyl benzoate-type epoxy resin, diphenyl sulfide-type epoxy resin, diphenyl sulfoxide-type epoxy resin, diphenylsulfone-type epoxy resin, diphenyl disulfide-type epoxy resin, naphthalene-type epoxy resin, anthracene-type epoxy resin, hydroquinone-type epoxy resin, methylhydroquinone-type epoxy resin, dibutylhydroquinone-type epoxy resin, resorcinol-type epoxy resin, methylresorcinol-type epoxy resin, catechol-type epoxy resin, and N,N-diglycidyl aniline-type epoxy resin.

One of these epoxy resins may be used singly, or two or more thereof may be used in combination.

Other examples thereof include trifunctional epoxy resins such as N,N-diglycidyl aminobenzene-type epoxy resin, o-(N,N-diglycidyl amino)toluene-type epoxy resin, and triazine-type epoxy resin. One of these epoxy resins may be used, or two or more thereof may be used in combination.

Further examples thereof include tetrafunctional epoxy resins such as naphthalene-type tetrafunctional epoxy resin, tetraglycidyl diaminodiphenylmethane-type epoxy resin, and diaminobenzene-type epoxy resin. One of these epoxy resins may be used, or two or more thereof may be used in combination.

Further examples thereof include polyfunctional epoxy resins such as phenol novolac-type epoxy resin, cresol novolac-type epoxy resin, triphenylmethane-type epoxy resin, tetraphenylethane-type epoxy resin, dicyclopentadiene-type epoxy resin, naphthol aralkyl-type epoxy resin, and brominated phenol novolac-type epoxy resin. One of these epoxy resins may be used, or two or more thereof may be used in combination.

Further examples thereof include diepoxy resins such as (poly)ethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene ether glycol diglycidyl ether, glycerin diglycidyl ether, neopentyl glycol diglycidyl ether, cyclohexane-type diglycidyl ether, and dicyclopentadiene-type diglycidyl ether. One of these epoxy resins may be used, or two or more thereof may be used in combination.

Further examples thereof include triepoxy resins such as trimethylolpropane triglycidyl ether and glycerin triglycidyl ether. One of these epoxy resins may be used, or two or more thereof may be used in combination.

Further examples thereof include alicyclic epoxy resins such as vinyl(3,4-cyclohexene) dioxide and 2-(3,4-epoxycyclohexyl)-5,1-spiro-(3,4-epoxycyclohexyl)-m-dioxane. One of these epoxy resins may be used, or two or more thereof may be used in combination.

Further examples thereof include glycidyl amine-type epoxy resins such as tetraglycidyl bis(aminomethyl)cyclohexane.

Further examples thereof include: hydantoin-type epoxy resins such as 1,3-diglycidyl-5-methyl-5-ethylhydantoin; and epoxy resins having a silicone skeleton such as 1,3-bis(3-glycidoxypropyl)-1,1,3,3-tetramethyldisiloxane. One of these epoxy resins may be used, or two or more thereof may be used in combination.

Further examples thereof include aliphatic epoxy resins and alicyclic epoxy resins that can be used as reactive diluents, such as 2-ethyl hexyl glycidyl ether, cyclohexanedimethanol diglycidyl ether, neopentyl glycol diglycidyl ether, 1,6-hexanediol diglycidyl ether, ethylene glycol diglycidyl ether, hydrogenated bisphenol A-type epoxy resin, silicone-modified epoxy resin, (poly)ethylene glycol diglycidyl ether, (poly)propylene glycol diglycidyl ether, butanediol diglycidyl ether, trimethylolpropane diglycidyl ether, polytetramethylene ether glycol diglycidyl ether, glycerin diglycidyl ether, neopentyl glycol diglycidyl ether, cyclohexane-type diglycidyl ether, dicyclopentadiene-type diglycidyl ether, trimethylolpropane triglycidyl ether, glycerin triglycidyl ether, vinyl(3,4-cyclohexene) dioxide, 2-(3,4-epoxycyclohexyl)-5,1-spiro-(3,4-epoxycyclohexyl)-m-dioxane, glycidyl amine-type epoxy resins such as tetraglycidyl bis(aminomethyl)cyclohexane, 1,3-diglycidyl-5-methyl-5-ethylhydantoin-type epoxy resin, 1,3-bis(3-glycidoxypropyl)-1,1,3,3-tetramethyldisiloxane-type epoxy resin, phenyl glycidyl ether, cresyl glycidyl ether, p-sec-butyl phenyl glycidyl ether, styrene oxide, p-tert-butyl phenyl glycidyl ether, o-phenyl phenol glycidyl ether, p-phenyl phenol glycidyl ether, N-glycidyl phthalimide, n-butyl glycidyl ether, 2-ethyl hexyl glycidyl ether, α-pinene oxide, allyl glycidyl ether, 1-vinyl-3,4-epoxycyclohexane, 1,2-epoxy-4-(2-methyloxiranyl)-1-methylcyclohexane, 1,3-bis(3-glycidoxypropyl)-1,1,3,3-tetramethyldisiloxane, and neodecanoic acid glycidyl ester. One of these epoxy resins may be used singly, or two or more thereof may be used in combination.

The epoxy resin composition of the present embodiment preferably comprises, as the epoxy resin (a), a liquid epoxy resin having a bisphenol A-type structure, a bisphenol F-type structure, a bisphenol AF-type structure, a naphthalene structure, a glycidyl ester structure, a glycidyl amine structure, a phenol novolac structure, a cyclohexane structure, a cyclohexanedimethanol structure, or a butadiene structure, or an alicyclic liquid epoxy resin having an ester skeleton, from the viewpoint of the strength of a cured product.

Examples of the liquid epoxy resin include, but are not limited to, trade names: EXA850CRP (BisA-type epoxy resin), EXA830CRP (BisF-type epoxy resin), HP4032, HP4032D, and HP4032SS (naphthalene-type epoxy resin) manufactured by DIC Corp., trade names: jER828US, jER828EL, jER825 (bisphenol A-type epoxy resin), jER807, jER1750 (bisphenol F-type epoxy resin), jER152 (phenol novolac-type epoxy resin), jER630, and jER630LSD (glycidyl amine-type epoxy resin) manufactured by Mitsubishi Chemical Group Corp., trade names: ZX1059 (mixed product of bisphenol A-type epoxy resin and bisphenol F-type epoxy resin), "ZX1658", and "ZX1658GS" (1,4-glycidyl cyclohexane-type liquid epoxy resin) manufactured by NIPPON STEEL Chemical & Material Co., Ltd., trade name: EX-721 (glycidyl ester-type epoxy resin) manufactured by Nagase ChemteX Corp., trade names: CELLOXIDE 2021P (alicyclic epoxy resin having an ester skeleton) and EPOLEAD PB-3600 (epoxy resin having a butadiene structure) manufactured by Daicel Corp., trade name: JP-100, JP-200 (epoxy resin having a butadiene structure) manufactured by Nippon Soda Co., Ltd., and trade name: AER9000 (epoxy resin containing a special soft skeleton) manufactured by Asahi Kasei Corp.

One of these epoxy resins may be used singly, or two or more thereof may be used in combination.

It is preferred to comprise a solid epoxy resin because the epoxy resin (a) can improve the heat resistance of the resulting cured product or the strength of the cured product.

Such a solid epoxy resin is more preferably a solid epoxy resin having a biphenyl-type structure, a bixylenol structure, a naphthalene structure, a cresol novolac structure, a dicyclopentadiene structure, a trisphenol structure, a naphthol structure, a naphthylene ether structure, an anthracene structure, a bisphenol A-type structure, a bisphenol AF-type structure, a tetraphenylethane structure, a bisphenol acetophenone structure, or a fluorene structure.

Examples of the solid epoxy resin include, but are not limited to, trade names: HP-4700, HP-4710 (naphthalene-type tetrafunctional epoxy resin), N-690, N-695 (cresol novolac-type epoxy resin), HP-7200, HP-7200H, HP-7200HH (dicyclopentadiene-type epoxy resin), HP-6000, HP-6000L, EXA-7311, EXA-7311-G3, EXA-7311-G4, and EXA-7311-G4S (naphthylene ether-type epoxy resin) manufactured by DIC Corp., trade names: EPPN-502H (trisphenol-type epoxy resin), NC3000, NC3000H, NC3000L, NC3100 (biphenyl-type epoxy resin), and NC-7000L (naphthol novolac-type epoxy resin) manufactured by Nippon Kayaku Co., Ltd., trade names: ESN475V and ESN485 (naphthol-type epoxy resin), manufactured by Nippon Steel & Sumikin Chemical Co., Ltd., trade names: YX4000, YX4000H, YX4000HS, YL6121 (biphenyl-type epoxy resin), YX4000HK (bixylenol-type epoxy resin), YX8800 (anthracene-type epoxy resin), YX7700 (novolac-type epoxy resin containing a xylene structure), YL7760 (bisphenol AF-type epoxy resin), YL7800 (fluorene-type epoxy resin), jER1010 (bisphenol A-type solid epoxy resin), and jER1031S (tetraphenylethane-type epoxy resin) manufactured by Mitsubishi Chemical Group Corp., and trade names: OGSOL PG-100 and CG-500 (fluorene-type epoxy resin) manufactured by Osaka Gas Chemicals Co., Ltd. One of these epoxy resins may be used singly, or two or more thereof may be used in combination.

The liquid epoxy resin and the solid epoxy resin are preferably used in combination as the epoxy resin (a) from the viewpoint of being able to confer the effects mentioned above in a well-balanced manner.

In the case of using the liquid epoxy resin and the solid epoxy resin in combination, their mass ratio (liquid epoxy resin:solid epoxy resin) is preferably in the range of 1:0.1 to 1:6.

The mass ratio between the liquid epoxy resin and the solid epoxy resin falls within the above range, whereby the epoxy resin composition of the present embodiment produces effects, for example, (I) tackiness and close contact are more favorable for use in the form of a film, (II) sufficient flexibility is obtained for use in the form of a film, and handleability is improved, and (III) a cured product having sufficient breaking strength can be obtained, and the reliability of a printed wiring board or a semiconductor chip package, and an electronic device comprising the same can be improved.

The mass ratio between the liquid epoxy resin and the solid epoxy resin (liquid epoxy resin: solid epoxy resin) is more preferably in the range of 1:0.3 to 1:5, further preferably in the range of 1:0.6 to 1:4, from the viewpoint of the effects (I) to (III).

The epoxy resin (a) has an epoxy equivalent of preferably 50 g/eq. to 5000 g/eq., more preferably 50 g/eq. to 3000 g/eq., further preferably 80 g/eq. to 2000 g/eq., still further preferably 100 g/eq. to 1000 g/eq., even further preferably 120 to 900 g/eq.

The epoxy equivalent falls within the above numeric range, whereby a cured product of the epoxy resin composition of the present embodiment has a sufficient cross-link density and produces a cured product excellent in strength.

The epoxy equivalent is the mass of a resin containing 1 equivalent of an epoxy group.

The epoxy equivalent can be measured in accordance with JIS K7236.

For the epoxy resin (a), the total chlorine content of the epoxy resin is preferably 2500 ppm or less, more preferably 2000 ppm or less, further preferably 1500 ppm or less, still further preferably 900 ppm or less, from the viewpoint of obtaining an epoxy resin composition excellent in balance between curability and storage stability while having excellent electric characteristics.

The total chlorine content of the epoxy resin (a) is preferably 0.01 ppm or more, more preferably 0.02 ppm or more, further preferably 0.05 ppm or more, still further preferably 0.1 ppm or more, even further preferably 0.2 ppm or more, particularly preferably 0.5 ppm or more, from the viewpoint of suppressing excessive reduction.

In this context, the total chlorine content refers to the total amount of organic chlorine and inorganic chlorine contained in the epoxy resin (a), and is a mass-based value with respect to the epoxy resin (a).

The total chlorine content of the epoxy resin (a) is measured by the following method.

The epoxy resin (a) is repetitively washed and filtered using xylene until the epoxy resin is no longer found in the washing solution xylene. Next, the solvent in the filtrate is distilled off under reduced pressure at 100°C or lower to obtain an epoxy resin. 1 to 10 g of the obtained epoxy resin sample is precisely weighed such that a titer is 3 to 7 mL. This sample is dissolved in 25 mL of ethylene glycol monobutyl ether. To this solution, 25 mL of a solution of 1 N KOH in propylene glycol is added, and the mixture is boiled for 20 minutes, followed by titration with an aqueous silver nitrate solution. The total chlorine content is calculated from the titer.

The content of the epoxy resin (a) in the epoxy resin composition of the present embodiment can be appropriately set depending on desired performance and is not particularly limited. The content is preferably 5% by mass or more, more preferably 7.5% by mass or more, further preferably 10% by mass or more, still further preferably 12% by mass or more, even further preferably 14% by mass or more, in all involatile components except for a solvent from the viewpoint of curability.

The content is preferably 80% by mass or less, more preferably 70% by mass or less, further preferably 60% by mass or less, still further preferably 55% by mass or less, even further preferably 50% by mass or less, in all involatile components except for a solvent from the viewpoint of the handleability of the epoxy resin composition of the present embodiment and a film comprising the epoxy resin composition of the present embodiment.

### (Component (d):filler)

The epoxy resin composition of the present embodiment can further comprise component (d): a filler (hereinafter, also referred to as a filler (d) or a component (d)).

The filler (d) is, but not limited to, one or two or more members selected from the group consisting of an inorganic filler and an inorganic filler treated in advance with a silane coupling agent (g) mentioned later, from the viewpoint of reducing the warpage of a base material having a cured product of the epoxy resin composition of the present embodiment as well as an organic filler from the viewpoint of improving adhesion strength and improving crack resistance.

One of these fillers may be used singly, or two or more thereof may be used in combination.

The filler (d) is not particularly limited by its shape and may be in any form, for example, an amorphous, spherical, or scale-like form.

It is preferred to comprise an inorganic filler as the component (d) from the viewpoint of allowing the epoxy resin composition of the present embodiment and an adherend base material to have similar coefficients of linear expansion, and reducing the warpage of a base material having a cured product of the epoxy resin composition of the present embodiment.

Examples of the inorganic filler include, but are not limited to, ceramics such as silica, alumina, glass, cordierite, silicone oxide, barium sulfate, barium carbonate, talc, clay, mica powders, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium zirconate titanate, barium zirconate, calcium zirconate, zirconium phosphate, and zirconium tungstate phosphate, carbons such as carbon nanotube and graphene, metals or alloys such as gold, silver, copper, nickel, aluminum, zinc, tin, lead, solder, indium, and palladium, and particles of polymer core materials coated with metal thin films.

Among them, it is preferred to comprise silica from the viewpoint of more reducing the warpage of a cured product. Examples of the silica include amorphous silica, fused silica, crystalline silica, synthetic silica, and hollow silica. Its shape is more preferably a spherical shape from the viewpoint of favorable filling properties or handleability of the epoxy resin composition.

Examples of the commercially available spherical fused silica include trade names: SO-C2, SO-C1, SO-E2, and SO-E1 manufactured by Admatechs Co., Ltd.

The average particle size of the filler (d) is not particularly limited and is preferably 3 µm or smaller, more preferably 2 µm or smaller, further preferably 1 µm or smaller, 0.7 µm or smaller, 0.5 µm or smaller, 0.4 µm or smaller, or 0.3 µm or smaller, from the viewpoint of being able to form a cured product layer using the epoxy resin composition containing the component (d) and form fine wiring on the cured product layer.

On the other hand, the average particle size of the component (d), i.e., the filler, is preferably 0.01 µm or larger, more preferably 0.03 µm or larger, further preferably 0.05 µm or larger, 0.07 µm or larger, or 0.1 µm or larger, from the viewpoint of attaining a moderate viscosity and preparing a resin paste having favorable handleability in forming a resin paste using the epoxy resin composition of the present embodiment.

The average particle size of the filler can be measured by a laser diffraction/scattering method based on the Mie scattering theory. Specifically, the particle size distribution of the filler is prepared on a volume basis with a laser diffraction particle size distribution analyzer, and a median size thereof can be measured as the average particle size. For example, trade name: HELOS manufactured by Sympatec GmbH can be used as the laser diffraction particle size distribution analyzer.

In the case of using the inorganic filler as the filler (d), the content of the inorganic filler in the epoxy resin composition of the present embodiment can be appropriately set depending on desired performance and is not particularly limited. The content is preferably 5 to 98% by mass, more preferably 10 to 95% by mass, further preferably 15 to 90% by mass, still further preferably 20 to 88% by mass, even further preferably 25 to 85% by mass, particularly preferably 30 to 80% by mass.

Within this range, the epoxy resin composition and the film of the present embodiment can further exert effects (i) to (iii): (i) a proper viscosity can be kept, and handleability is excellent, (ii) the amounts of a resin component and the inorganic filler fall within right ranges so that adhesion, close contact, and dimensional stability are excellent, and (iii) warpage, heat resistance, and breaking strength are excellent when the resin composition is cured.

The organic filler has a function as an impact-resistant relaxing agent having stress relaxing properties. The epoxy resin composition of the present embodiment contains the organic filler, whereby adhesion to various connection members can be further improved, and the generation and progression of fillet cracks tend to be able to be suppressed.

Examples of the organic filler include acrylic resins, silicone resins, butadiene rubber, polyester, polyurethane, polyvinyl butyral, polyarylate, polymethyl methacrylate, acrylic rubber, polystyrene, acrylonitrile-butadiene rubber (NBR), styrene-butadiene rubber (SBR), silicone-modified resins, and organic fine particles of copolymers containing these components. The organic fine particles are preferably an alkyl (meth)acrylate-butadiene-styrene copolymer, an alkyl (meth)acrylate-silicone copolymer, a silicone-(meth)acrylic copolymer, a composite of silicone and (meth)acrylic acid, a composite of alkyl (meth)acrylate-butadienestyrene and silicone, or a composite of alkyl (meth)acrylate and silicone, from the viewpoint of improvement in adhesion.

Organic fine particles having a core-shell structure where a core layer and a shell layer differ in composition can also be used as the organic filler.

Examples of the core-shell organic fine particles include, but are not limited to, particles of acrylic resins grafted to silicone-acrylic rubber as a core, and particles of acrylic resins grafted to acrylic copolymers.

The modulus of elasticity is reduced by the contained core-shell organic fine particles, whereby stress generated in a fillet moiety is reduced, and fillet cracks tend to be able to be prevented. If fillet cracks occur, the contained core-shell organic fine particles act as a stress relaxing agent and tend to suppress the progression of the fillet cracks.

A material excellent in softness is preferably used as a material constituting the core layer. Examples of the material constituting the core layer include, but are not limited to, silicone-based elastomers, butadiene-based elastomers, styrene-based elastomers, acrylic elastomers, polyolefin-based elastomers, and silicone/acrylic composite-based elastomers.

On the other hand, a material constituting the shell layer is preferably a material excellent in affinity for other components of a semiconductor resin sealing material, particularly, affinity for an epoxy resin. Examples of the material constituting the shell layer include, but are not limited to, acrylic resins and epoxy resins. Among them, an acrylic resin is particularly preferred from the viewpoint of affinity for other components of a sealing material, particularly, affinity for an epoxy resin.

In the case of using the organic filler as the filler (d), the content of the organic filler in the epoxy resin composition of the present embodiment can be appropriately set depending on desired performance and is not particularly limited. The content is preferably 1 to 20% by mass, more preferably 2 to 18% by mass, further preferably 3 to 16% by mass, in all involatile components except for a solvent.

The content of the organic filler is 1% by mass or more, whereby stress relaxation works, and an effect of improving adhesive force tends to be obtained.

The content of the organic filler is 20% by mass or less, whereby an effect of thermal reflow resistance tends to be obtained.

### (Component (e): phenol compound, active ester compound, and/or cyanate ester compound)

The epoxy resin composition of the present embodiment can further comprise at least one member selected from the group consisting of a phenol compound, an active ester compound, and a cyanate ester compound (hereinafter, also referred to as a component (e)).

The component (e) can function as a curing agent in the epoxy resin composition of the present embodiment.

One of such components (e) may be used singly, or two or more thereof may be used in combination.

Examples of the phenol compound include, but are not limited to, phenol novolac compound, triazine skeleton-containing phenol compound, phenol aralkyl compounds, cresol aralkyl compounds, naphthol aralkyl compounds, biphenyl-modified phenol compounds, biphenyl-modified phenol aralkyl compounds, dicyclopentadiene-modified phenol compounds, aminotriazine-modified phenol compounds, naphthol novolac compounds, naphthol-phenol co-condensed novolac compounds, naphthol-cresol co-condensed novolac compounds, and allyl acryl phenol compounds. A triazine skeleton-containing phenol compound is preferred.

The triazine skeleton-containing phenol compound functions as a curing agent for epoxy resins and has both of a triazine skeleton and a structure derived from a phenol compound in one molecule. This curing agent is generally produced by the condensation of a phenol compound, a compound having a triazine ring, such as melamine or benzoguanamine, and formaldehyde.

The epoxy resin composition of the present embodiment comprises the triazine skeleton-containing phenol compound, whereby a coefficient of linear expansion can be kept low because of being derived from a triazine skeleton; thus, the warpage of a base material having a cured product of the epoxy resin composition of the present embodiment can be decreased, and heat resistance, strength, and close contact with a base material tend to be favorable.

The nitrogen content of the triazine skeleton-containing phenol compound is preferably 2% by mass or more, more preferably 4% by mass or more, further preferably 5% by mass or more, still further preferably 6% by mass or more, even further preferably 7% by mass or more, from the viewpoint of more improving the heat resistance, strength, and close contact with a base material.

On the other hand, the nitrogen content of the triazine skeleton-containing phenol compound is preferably 50% by mass or less, more preferably 40% by mass or less, further preferably 30% by mass or less, still further preferably 25% by mass or less, even further preferably 20% by mass or less, from the viewpoint of keeping the stability of the epoxy resin composition of the present embodiment and the cross-link density of a cured product within proper ranges.

The triazine skeleton-containing phenol compound preferably comprises a phenol novolac structure from the viewpoint of more elevating a cross-link density.

Examples of the triazine skeleton-containing phenol compound comprising a phenol novolac structure include, but are not limited to, trade names: LA3018, LA3018-50P, LA7052, LA7054, and LA1356 manufactured by DIC Corp.

The active ester compound functions as a curing agent for epoxy resins and has active ester in a molecule.

The epoxy resin composition of the present embodiment comprises the active ester compound, whereby a hydroxy group, which is responsible for increase in dielectric dissipation factor, derived from the reaction of active ester with an epoxy group does not appear in the epoxy resin composition; thus, the dielectric dissipation factor tends to be able to be decreased.

The active ester compound is not particularly limited and is preferably a compound having two or more active ester groups in one molecule from the viewpoint of securing a high cross-link density. The active ester-based curing agent is more preferably an active ester compound obtained by reacting a carboxylic acid compound and/or a thiocarboxylic acid compound with a hydroxy compound and/or a thiol compound, further preferably an active ester compound obtained by reacting a carboxylic acid compound with one or two or more members selected from a phenol compound, a naphthol compound, and a thiol compound, from the viewpoint of the heat resistance and the like of the epoxy resin composition of the present embodiment. The active ester-based curing agent is still further preferably an aromatic compound having two or more active ester groups in one molecule, the aromatic compound being obtained by reacting a carboxylic acid compound with an aromatic compound having a phenolic hydroxy group. The active ester-based curing agent is even further preferably an aromatic compound obtained by reacting a compound having at least two or more carboxylic acids in one molecule with an aromatic compound having a phenolic hydroxy group, or an aromatic compound having two or more active ester groups in one molecule of the aromatic compound described above.

The active ester compound may be linear or branched. The compound having at least two or more carboxylic acids in one molecule tends to be able to enhance compatibility with the epoxy resin (a) when being a compound containing an aliphatic chain, and tends to be able to enhance heat resistance when being a compound having an aromatic ring.

In this context, examples of the carboxylic acid compound for use in obtaining the active ester compound include, but are not limited to, benzoic acid, acetic acid, succinic acid, maleic acid, itaconic acid, phthalic acid, isophthalic acid, terephthalic acid, and pyromellitic acid. The carboxylic acid compound is preferably succinic acid, maleic acid, itaconic acid, phthalic acid, isophthalic acid, or terephthalic acid, more preferably isophthalic acid or terephthalic acid, particularly, from the viewpoint of the heat resistance of the epoxy resin composition of the present embodiment.

Examples of the thiocarboxylic acid compound include, but are not limited to, thioacetic acid and thiobenzoic acid.

Examples of the phenol compound or the naphthol compound for use in obtaining the active ester compound include, but are not limited to, hydroquinone, resorcinol, bisphenol A, bisphenol F, bisphenol S, phenolphthalein, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, and phenol novolac.

Among them, the phenol or naphthol compound is preferably bisphenol A, bisphenol F, bisphenol S, methylated bisphenol A, methylated bisphenol F, methylated bisphenol S, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, or phenol novolac, more preferably catechol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucinol, benzenetriol, dicyclopentadienyl diphenol, or phenol novolac, further preferably 1,5-dihydroxynaphthalene, 1,6-dihydroxynaphthalene, 2,6-dihydroxynaphthalene, dihydroxybenzophenone, trihydroxybenzophenone, tetrahydroxybenzophenone, dicyclopentadienyl diphenol, or phenol novolac, still further preferably dihydroxybenzophenone, trihydroxybenzophenone, tetrahydroxybenzophenone, dicyclopentadienyl diphenol, or phenol novolac, even further preferably dicyclopentadienyl diphenol or phenol novolac, particularly preferably dicyclopentadienyl diphenol, from the viewpoint of the heat resistance of the epoxy resin composition of the present embodiment and solubility in the epoxy resin or a solvent.

Examples of the thiol compound include, but are not limited to, benzenedithiol and triazinedithiol.

An active ester compound disclosed in Japanese Patent Laid-Open No. 2004-277460 or 2013-40270 may be used as the active ester compound, and a commercially available active ester compound can also be used. Examples of the commercially available active ester compound include, but are not limited to, trade names: EXB9451, EXB9460, EXB9460S, HPC-8000-65T (active ester compound having a dicyclopentadiene-type diphenol structure), EXB9416-70BK (active ester compound having a naphthalene structure), and EXB9050L-62M (phosphorus atom-containing active ester compound) manufactured by DIC Corp., and trade names: DC808 (active ester compound containing an acetylated product of phenol novolac) and YLH1026 (active ester compound containing a benzoylated product of phenol novolac) manufactured by Mitsubishi Chemical Group Corp.

The cyanate ester compound functions as a curing agent for epoxy resins and has a cyanate group in a molecule. The epoxy resin composition of the present embodiment comprises the cyanate ester compound, whereby flexibility is imparted to the epoxy resin composition by forming an oxazoline ring or an oxazolidinone ring through reaction with an epoxy group, while triazine skeleton formation occurs by the trimerization of a cyanate group; thus, heat resistance tends to be able to be favorable while the warpage of a base material having a cured product of the epoxy resin composition of the present embodiment is reduced. Furthermore, a hydroxy group is unlikely to appear during reaction with an epoxy group; thus, a dielectric dissipation factor tends to be able to be kept low.

Examples of the cyanate ester compound include, but are not limited to, novolac-type (phenol novolac-type, alkylphenol novolac-type, etc.) cyanate ester resin, dicyclopentadiene-type cyanate ester resin, bisphenol-type (bisphenol A-type, bisphenol F-type, bisphenol S-type, etc.) cyanate ester resin, and prepolymers obtained by partially converting these resins to triazine. Examples of the cyanate ester resin include, but are not limited to, bifunctional cyanate resins such as bisphenol A dicyanate, polyphenol cyanate (oligo(3-methylene-1,5-phenylene cyanate), 4,4'-methylenebis(2,6-dimethylphenyl cyanate), 4,4'-ethylidene diphenyl dicyanate, hexafluorobisphenol A dicyanate, 2,2-bis(4-cyanato)phenylpropane, 1,1-bis(4-cyanatophenylmethane), bis(4-cyanato-3,5-dimethylphenyl)methane, 1,3-bis(4-cyanatophenyl-1-(methylethylidene))benzene, and bis(4-cyanatophenyl)thio ether, bis(4-cyanatophenyl) ether, polyfunctional cyanate resins such as phenol novolac, cresol novolac, and dicyclopentadiene structure-containing phenol resin, and prepolymers obtained by partially converting these cyanate resins to triazine.

One of these resins may be used singly, or two or more thereof may be used in combination.

Examples of the commercially available cyanate ester resin include trade name: CYTESTER(R) TA (bisphenol A-type cyanate ester resin) manufactured by Mitsubishi Gas Chemical Co., Inc.

One of the phenol compound, the active ester compound, and the cyanate ester compound may be used singly. Two or more thereof are preferably combined, the phenol compound and the active ester compound or the phenol compound and the cyanate ester compound are more preferably combined, and the triazine skeleton-containing phenol compound and the active ester compound or the triazine skeleton-containing phenol compound and the cyanate ester compound are more preferably combined, from the viewpoint of securing close contact and adhesion while achieving a low dielectric dissipation factor for a cured product of the epoxy resin composition of the present embodiment and keeping warpage small for a base material having a cured product of the epoxy resin composition of the present embodiment.

The mass ratio between the curing agents in combining two of the phenol compound, the active ester compound, and the cyanate ester compound is not particularly limited and can be properly set depending on desired physical properties by those skilled in the art. For example, in the case of combining the active ester compound and the phenol compound, the mass ratio with the active ester compound defined as 1 is preferably 1:0.05 to 1:1.5, more preferably 1:0.05 to 1:1, further preferably 1:0.07 to 1:0.8, still further preferably 1:0.1 to 1:0.6, from the viewpoint of achieving a low dielectric dissipation factor for a cured product of the epoxy resin composition of the present embodiment and keeping warpage small for a base material having a cured product of the epoxy resin composition of the present embodiment, and from the viewpoint of favorably achieving close contact and adhesion.

For example, in the case of combining the cyanate ester compound and the phenol compound, the mass ratio with the cyanate ester compound defined as 1 is preferably 1:0.05 to 1:2.0, more preferably 1:0.1 to 1:1.5, further preferably 1:0.2 to 1:1.2, still further preferably 1:0.3 to 1:1, from the same viewpoint as above.

The content of the component (e): the phenol compound, the active ester compound, or the cyanate ester compound in the epoxy resin composition of the present embodiment can be appropriately set depending on desired performance and is not particularly limited. When the number of epoxy groups in the epoxy resin (a) is 1, the number of reactive groups in the component (e) is preferably 0.1 to 3, more preferably 0.15 to 2.5, further preferably 0.2 to 2, still further preferably 0.3 to 1.8, even further preferably 0.35 to 1.5, particularly preferably 0.5 to 1.2, from the viewpoint of adjusting the cross-link density of the component (a) and the phenol compound, the active ester compound, or the cyanate ester compound to a proper range and preventing an unreacted functional group from remaining. These preferred ranges are also applied when two or more of the phenol compound, the active ester compound, and the cyanate ester compound are used in combination.

In this context, the "number of epoxy groups" is a value obtained by dividing the mass of each epoxy resin present in the epoxy resin composition by an epoxy equivalent and adding up the resulting values as to all epoxy resins. The "reactive group" means a functional group that can react with an epoxy group, and is a value obtained by dividing the mass of a component by a reactive group equivalent as to each of the phenol compound, the active ester compound, and the cyanate ester compound present in the epoxy resin composition and adding up all the resulting values.

### (Component (f): polymer)

The epoxy resin composition of the present embodiment can comprise component (f): a polymer (hereinafter, also referred to as a polymer (f) or a component (f)).

The polymer (f) is a polymer different from the component (a) and the component (e).

The epoxy resin composition of the present embodiment comprises the polymer (f), whereby in the case of molding the epoxy resin composition of the present embodiment into a film by casting or by coating and drying at a given thickness, cracks or breakage is prevented, and the film shape can be maintained.

Examples of the polymer (f) include, but are not limited to, phenoxy resins, polyvinylacetal resins, acid anhydride group-containing vinyl resins, polyolefin resins, polybutadiene resins, polyimide resins, polyamideimide resins, styrene-based elastomer resins, polyethersulfone resins, polyphenylene ether resins, polysulfone resins, and acrylic resins.

One of these polymers (f) may be used singly, or two or more thereof may be used in combination.

The weight-average molecular weight of the polymer (f) is preferably 5000 or higher, more preferably 10000 or higher, further preferably 20000 or higher, still further preferably 25000 or higher, from the viewpoint of obtaining a cured layer having sufficient strength. The upper limit of the weight-average molecular weight of the polymer (f) is preferably 300000 or lower, more preferably 200000 or lower, further preferably 150000 or lower, still further preferably 130000 or lower. The weight-average molecular weight of the polymer (f) can be measured by, for example, gel permeation chromatography (GPC). Specifically, the weight-average molecular weight (polystyrene-based) of the polymer (f) can be calculated by using HLC-8320GPC manufactured by Tosoh Corp. as a measurement apparatus, SHODEX KF-804/KF-803/KF-802/KF-802 manufactured by Resonac Corp. as a column, and tetrahydrofuran or the like as a mobile phase, performing measurement at a column temperature of 40°C, and using a calibration curve of standard polystyrene.

The polymer (f) preferably has a functional group containing one or more atoms selected from the group consisting of an oxygen atom, a nitrogen atom, and a sulfur atom, or a carbon-carbon double bond, from the viewpoint of elevating the cross-link density of a cured product of the epoxy resin composition of the present embodiment and attaining sufficient heat resistance and strength of a cured product layer. The functional group is one or more members selected from the group consisting of a hydroxy group, a carboxy group, an acid anhydride group, an epoxy group, an amino group, a thiol group, an enol group, an enamine group, a urea group, a cyanate group, an isocyanate group, a thioisocyanate group, a diimide group, an alkenyl group, an arene group, and a ketene group. The acid anhydride group is preferably a carboxylic anhydride group. Preferred examples of the alkenyl group include a vinyl group, an allyl group, and a styryl group. When the polymer (f) contains such a functional group, the functional group equivalent of the polymer (f) is preferably 100000 or less, more preferably 90000 or less, 80000 or less, 70000 or less, 60000 or less, 50000 or less, 40000 or less, 30000 or less, 20000 or less, 10000 or less, 8000 or less, 6000 or less, or 5000 or less. The lower limit of the functional group equivalent is not particularly limited and can be usually 50 or more or 100 or more, for example.

Hereinafter, suitable polymers (f) will be described in more detail. Thermoplastic resin prepared by further adding the functional groups described above to the following thermoplastic resins can also be suitably used as the component (f) according to known procedures.

For example, but not limited to, a phenoxy resin having one or more skeletons selected from the group consisting of a bisphenol A skeleton, a bisphenol F skeleton, a bisphenol S skeleton, a bisphenol acetophenone skeleton, a phenol novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton can be suitably used as the phenoxy resin. The phenoxy resin may have any terminal functional group such as a phenolic hydroxy group or an epoxy group.

Specific examples of the phenoxy resin include trade names: 1256, 4250 (bisphenol A skeleton-containing phenoxy resin), YX8100 (bisphenol S skeleton-containing phenoxy resin), YX6954, YX6954BH30 (bisphenol acetophenone skeleton-containing phenoxy resin), YX7553, YX7553BH30 (biscresol fluorenone skeleton-containing phenoxy resin), YL6794 (terpene skeleton-containing phenoxy resin), YL7213, YL7290 (trimethylcyclohexane skeleton-containing phenoxy resin), YL7500BH30, YL7769BH30, and YL7482 manufactured by Mitsubishi Chemical Group Corp., and trade names: FX280 and FX293 (bisphenol fluorenone skeleton-containing phenoxy resin) manufactured by NIPPON STEEL Chemical & Material Co., Ltd.

Examples of the polyvinylacetal resin include, but are not limited to, trade names: Denka Butyral 4000-2, 5000-A, 6000-C, and 6000-EP from Denka Co., Ltd., and trade names: SLEC BH series, BX series, KS series (e.g., KS-1), BL series, and BM series manufactured by Sekisui Chemical Co., Ltd.

The acid anhydride group-containing vinyl resin can be obtained by, for example, but not limited to, the copolymerization of an acid anhydride group-containing monomer (f1) and an additional monomer (f2).

Examples of the acid anhydride group-containing monomer (f1) include, but are not limited to, maleic anhydride, itaconic anhydride, citraconic anhydride, and aconitic anhydride.

The additional monomer (f2) is not particularly limited as long as the monomer is copolymerizable with the acid anhydride group-containing monomer (f1). An ethylenic unsaturated monomer such as (meth)acrylic acid, (meth)acrylic acid ester, or styrene can be used.

Examples of the acid anhydride group-containing vinyl resin include, but are not limited to, trade names: EF-30, EF-40, EF-60, and EF-80 manufactured by Cray Valley SA.

Examples of the polyimide resin include, but are not limited to, trade names: RICACOAT SN-20 and PN-20 manufactured by New Japan Chemical Co., Ltd., and trade name: UNIDIC V-8000 manufactured by DIC Corp.

Examples of the polyimide resin also include, but are not limited to, modified polyimide such as linear polyimide obtained by reacting bifunctional hydroxyl group-terminated polybutadiene, a diisocyanate compound, and tetrabasic anhydride (Japanese Patent Laid-Open No. 2006-37083) and polysiloxane skeleton-containing polyimide (Japanese Patent Laid-Open No. 2002-12667, Japanese Patent Laid-Open No. 2000-319386, International Publication No. WO 2010/53186, etc.).

Examples of the polyamideimide resin include, but are not limited to, trade names: VYLOMAX HR11NN and HR16NN manufactured by Toyobo Co., Ltd., and trade names: HPC-5020, HPC-6000, HPC-7200, and HPC-9000 manufactured by Resonac Corp.

Examples of the styrene-based elastomer resin include, but are not limited to, block copolymers comprising a block of styrene or its analog as at least one terminal block and comprising an elastomer block of conjugated diene or its hydrogenated product as at least one intermediate block. Specific examples thereof include styrene-butadiene diblock copolymers, styrene-butadiene triblock copolymers, styrene-isoprene diblock copolymers, styrene-isoprene triblock copolymers, hydrogenated styrene-butadiene diblock copolymers, hydrogenated styrene-butadiene triblock copolymers, hydrogenated styrene-isoprene diblock copolymers, hydrogenated styrene-isoprene triblock copolymers, and hydrogenated styrene-butadiene random copolymers. Specific examples of the styrene-based elastomer resin include trade names: ASAPRENE, TUFPRENE, and ASAPLEX manufactured by Asahi Kasei Corp., and trade names: HYBRAR and SEPTON manufactured by Kuraray Co., Ltd.

Examples of the polyethersulfone resin include, but are not limited to, trade name: PES5003P manufactured by Sumitomo Chemical Co., Ltd.

Examples of the polysulfone resin include, but are not limited to, trade names: Polysulfone P1700 and P3500 manufactured by Solvay Advanced Polymers, LLC.

Examples of the polybutadiene resin include, but are not limited to, trade names: G-1000, G-3000, GI-1000, and GI-3000 manufactured by Nippon Soda Co., Ltd., trade name: R-45EPI manufactured by Idemitsu Petrochemical Co., Ltd., trade name: EPOFRIEND AT501 manufactured by Daicel Corp., and trade names: Ricon 130, Ricon 142, Ricon 150, Ricon 657, and Ricon 130MA manufactured by Cray Valley SA.

Examples of the acrylic resin include, but are not limited to, trade names: SG-P3, SG-600LB, SG-280, SG-790, and SG-K2 manufactured by Nagase ChemteX Corp., and trade names: SN-50, AS-3000E, and ME-2000 manufactured by Negami Chemical Industrial Co., Ltd.

Among them, it is preferred to comprise, as the polymer (f), one or more members selected from the group consisting of a phenoxy resin, a polyvinylacetal resin, an acid anhydride group-containing vinyl resin, a polyimide resin, a polyamideimide resin, a styrene-based elastomer resin, and an acrylic resin from the viewpoint of securing long-term connection reliability through sufficient heat resistance and strength of a cured product layer obtained using the epoxy resin composition of the present embodiment, and securing uniform curability by keeping compatibility proper with the epoxy resin (a).

In the case of applying the epoxy resin composition of the present embodiment to, for example, a material to be integrated in a bent form into an electronic device, such as a flexible wiring board, the contained polymer (f) can attain reduction in elasticity of a cured product layer of the epoxy resin composition and can suppress fracturing or peeling. For purposes requiring such reduction in elasticity, it is preferred to comprise, as the polymer (f), but not limited to, a resin having one or more structures selected from a polybutadiene structure, a polysiloxane structure, a poly(meth)acrylate structure, a polyalkylene structure, a polyalkyleneoxy structure, a polyisoprene structure, a polyisobutylene structure, and a polycarbonate structure in a molecule because an effect of reducing elasticity is easily obtained. A thermoplastic resin that has a glass transition temperature of 25°C or lower or is in a liquid state at 25°C can also be suitably used from the viewpoint of obtaining the effect of reducing elasticity.

The content of the polymer (f) in the epoxy resin composition of the present embodiment can be appropriately set depending on desired performance and is not particularly limited. The content is preferably 0.5% by mass or more, more preferably 1% by mass or more, further preferably 1.2% by mass or more, still further preferably 1.5% by mass or more, in all involatile components except for a solvent from the viewpoint of securing the close contact and flexibility of the epoxy resin composition of the present embodiment. The content is also preferably 50% by mass or less, more preferably 40% by mass or less, further preferably 30% by mass or less, still further preferably 20% by mass or less, from the viewpoint of keeping heat resistance and strength favorable for the epoxy resin composition of the present embodiment, in all involatile components except for a solvent.

### (Component (g): silane coupling agent)

The epoxy resin composition of the present embodiment may further comprise component (g): a silane coupling agent (hereinafter, also referred to as a silane coupling agent (g) or a component (g)).

It is preferred to comprise the silane coupling agent (g) because favorable affinity can be attained between a resin component and the filler (d) or between a resin component and an adherend, uniform dispersibility of the filler (d) is improved, and the adhesion of the epoxy resin composition can be improved.

In the present embodiment, the phrase "comprise a silane coupling agent (g)" means that in a process of obtaining the epoxy resin composition of the present embodiment, the silane coupling agent is integrated into the composition of the epoxy resin composition by any of the following methods (I) to (III).

### Method (I):

A method of treating the filler (d) with the silane coupling agent and blending the filler thus treated into the epoxy resin composition.

### Method (II):

A method of directly adding the silane coupling agent to the epoxy resin composition (integral blend method).

### Method (III):

A method of reacting the silane coupling agent with an end or a side chain of the epoxy resin (a) or the polymer (f) used, or blending a silylated resin using a resin of a monomer copolymerized with the silane coupling agent, for example.

Any of the methods (I) to (III) mentioned above may be used. The method (I) is preferred from the viewpoint that an alcohol serving as a by-product of silane coupling reaction is unlikely to remain in the system and from the viewpoint that the filler has much better dispersibility. The method (II) or (III) is preferred from the viewpoint that action can be made between the resin and the filler as well as between the resin and an adherend substrate, and adhesion and close contact can be more favorable.

The silane coupling agent (g) contains at least one hydrolyzable group such as an alkoxy group or an aryloxy group bonded to a silicon atom, and in addition to this, an alkyl group, an alkenyl group, or an aryl group may be bonded thereto. The alkyl group may be substituted by an amino group, an alkoxy group, an epoxy group, or a (meth)acryloyloxy group.

It is preferred to comprise, as the silane coupling agent (g), one or more silane coupling agents selected from, for example, an aminosilane-based coupling agent, an epoxysilane-based coupling agent, a mercaptosilane-based coupling agent, a styrylsilane-based coupling agent, an acrylate silane-based coupling agent, an isocyanate silane-based coupling agent, a sulfide silane-based coupling agent, a vinylsilane-based coupling agent, a silane-based coupling agent, an organosilazane compound, and a titanate-based coupling agent, from the viewpoint of improvement in uniform dispersibility of (d) the filler and improvement in adhesion and close contact of the resin composition.

Examples of the silane coupling agent (g) include, but are not limited to, aminosilane-based coupling agents such as 3-aminopropyltrimethoxysilane, 3-aminopropyltriethoxysilane, 3-aminopropyldiethoxymethylsilane, N-phenyl-3-aminopropyltrimethoxysilane, N-methylaminopropyltrimethoxysilane, N-2(-aminoethyl)-3-aminopropyltrimethoxysilane, and N-(2-aminoethyl)-3-aminopropyldimethoxymethylsilane, epoxysilane-based coupling agents such as 3-glycidyloxypropyltrimethoxysilane, 3-glycidyloxypropyltriethoxysilane, 3-glycidyloxypropylmethyldiethoxysilane, 3-glycidyloxypropyl(dimethoxy)methylsilane, glycidyl butyltrimethoxysilane, and 2-(3,4-epoxycyclohexyl)ethyltrimethoxysilane, mercaptosilane-based coupling agents such as 3-mercaptopropyltrimethoxysilane, 3-mercaptopropyltriethoxysilane, 3-mercaptopropylmethyldimethoxysilane, and 11-mercaptoundecyltrimethoxysilane, styrylsilane-based coupling agents such as P-styryltrimethoxysilane, acrylate silane-based coupling agents such as 3-acryloxypropyltrimethoxysilane, 3-methacryloxypropyltrimethoxysilane, 3-methacryloxypropyldimethoxysilane, 3-methacryloxypropyltriethoxysilane, and 3-methacryloxypropyldiethoxysilane, isocyanate silane-based coupling agents such as 3-isocyanatopropyltrimethoxysilane.

Examples of the silane coupling agents (g) include, but are not limited to, sulfide silane-based coupling agents such as bis(triethoxysilylpropyl) disulfide and bis(triethoxysilylpropyl) tetra sulfide, silane-based coupling agents such as methyltrimethoxysilane, octadecyltrimethoxysilane, phenyltrimethoxysilane, methacryloxypropyltrimethoxysilane, imidazole silane, triazine silane, and T-butyltrimethoxysilane, organosilazane compounds such as hexamethyldisilazane, 1,3-divinyl-1,1,3,3-tetramethyldisilazane, hexaphenyldisilazane, trisilazane, cyclotrisilazane, octamethylcyclotetrasilazane, hexabutyldisilazane, hexaoctyldisilazane, 1,3-diethyltetramethyldisilazane, 1,3-di-N-octyltetramethyldisilazane, 1,3-diphenyltetramethyldisilazane, 1,3-dimethyltetraphenyldisilazane, 1,3-diethyltetramethyldisilazane, 1,1,3,3-tetraphenyl-1,3-dimethyldisilazane, 1,3-dipropyltetramethyldisilazane, hexamethylcyclotrisilazane, dimethylaminotrimethylsilazane, and tetramethyldisilazane, and titanate-based coupling agents such as tetra-N-butyl titanate dimers, titanium-I-propoxyoctylene glycolate, tetra-N-butyl titanate, titanium octylene glycolate, diisopropoxy titanium bis(triethanol aminate), dihydroxy titanium bislactate, dihydroxy bis(ammonium lactate) titanium, bis(dioctyl pyrophosphate) ethylene titanate, bis(dioctyl pyrophosphate) oxyacetate titanate, tri-N-butoxy titanium monostearate, tetra-N-butyl titanate, tetra(2-ethylhexyl) titanate, tetraisopropylbis(dioctyl phosphite) titanate, tetraoctylbis(ditridecyl phosphite) titanate, tetra(2,2-diallyloxymethyl-1-butyl)bis(ditridecyl)phosphite titanate, isopropyltrioctanoyl titanate, isopropyltricumylphenyl titanate, isopropyltriisostearoyl titanate, isopropylisostearoyl diacryltitanate, isopropyldimethacrylisostearoyl titanate, isopropyltri(dioctyl phosphate) titanate, isopropyltridodecylbenzenesulfonyl titanate, isopropyl tris(dioctyl pyrophosphate) titanate, and isopropyltri(N-amidoethyl/aminoethyl) titanate.

One of these silane coupling agents may be used singly, or two or more thereof may be used in combination.

Among them, the silane coupling agent is preferably an aminosilane-based coupling agent, an epoxysilane-based coupling agent, a mercaptosilane-based coupling agent, or an organosilazane compound, more preferably an aminosilane-based coupling agent.

Examples of the commercially available product include trade names: KBM403 (3-glycidoxypropyltrimethoxysilane), KBM803 (3-mercaptopropyltrimethoxysilane), KBE903 (3-aminopropyltriethoxysilane), KBM573 (N-phenyl-3-aminopropyltrimethoxysilane), and SZ-31 (hexamethyldisilazane) manufactured by Shin-Etsu Chemical Co., Ltd.

The content of the silane coupling agent (g) in the epoxy resin composition of the present embodiment is not particularly limited and is preferably 0.1 to 2.0 parts by mass with respect to 100 parts by mass of the filler (d) from the viewpoint of suppressing excessive side reaction while attaining favorable dispersibility of the filler (d) and adhesion and close contact of the epoxy resin composition of the present embodiment.

### (Suitable form of epoxy resin composition)

The epoxy resin composition of the present embodiment in a preferred form comprises the epoxy resin (a), the compound represented by the formula (1) as the component (b), and the compound represented by the formula (2) as the component (c) and satisfies the following conditions.

Specifically, preferably, the epoxy resin composition of the present embodiment comprises, as (b): the compound represented by the formula (1), any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol, and as (c): the compound represented by the formula (2), any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid, wherein
a mass ratio between the component (b) and the component (c) is (b):(c) = 0.001:100 to 20:80, and
further comprises (d): a filler, (e): at least one member selected from the group consisting of a phenol compound, an active ester compound, and a cyanate ester compound, (f): a polymer (except for the component (a) and the component (e)), and (g): a silane coupling agent. The resulting epoxy resin composition thus configured causes little warpage of a base material having a cured product and is excellent in strength of the cured product and adhesion strength to a metal adherend.

### (Additive)

The epoxy resin composition of the present embodiment may further comprise, if necessary, an additive such as a compound having reactivity with the epoxy resin, a diluent, a reactive diluent, a pigment, a dye, a flow adjuster, a thickener, a reinforcing agent, a mold release agent, a wetting agent, a flame retardant, a surfactant, a stabilizer, an adhesion promoter, or a solvent, in addition to the components (a) to (g) mentioned above.

Examples of the compound having reactivity with the epoxy resin (a) include acid anhydride compounds, thiol compounds, aromatic amine compounds, guanidine compounds, and imidazole compounds except for the compounds of the formula (1) and the formula (2).

Examples of the acid anhydride compound include, but are not limited to, phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride. One of these compounds may be used, or two or more thereof may be used in combination.

The thiol compound can contain two or more thiol groups in one molecule. Examples thereof include, but are not limited to, 3,3'-dithiodipropionic acid, trimethylolpropane tris(thioglycolate), pentaerythritol tetrakis(thioglycolate), ethylene glycol dithioglycolate, 1,4-bis(3-mercaptobutyryloxy)butane, tris[(3-mercaptopropionyloxy)-ethyl]-isocyanurate, 1,3,5-tris(3-mercaptobutyloxyethyl)-1,3,5-triazine-2,4,6(1H,3H,5H)-trione, trimethylolpropane tris(3-mercaptopropionate), pentaerythritol tetrakis(3-mercaptopropionate), pentaerythritol tetrakis(3-mercaptobutyrate), dipentaerythritol hexakis(3-mercaptopropionate), 1,3,4,6-tetrakis(2-mercaptoethyl) glycoluril, 4-butanedithiol, 1,6-hexanedithiol, and 1,10-decanedithiol. The thiol-based curing agent is preferably 1,4-bis(3-mercaptobutyryloxy)butane, 1,3,5-tris(3-mercaptobutyloxyethyl)-1,3,5-triazine-2,4,6(1H,3H,5H)-trione, pentaerythritol tetrakis(3-mercaptopropionate), or pentaerythritol tetrakis(3-mercaptobutyrate) from the viewpoint of the impact resistance of a cured product of the epoxy resin composition of the present embodiment, more preferably pentaerythritol tetrakis(3-mercaptopropionate), pentaerythritol tetrakis(3-mercaptobutyrate) from the viewpoint of low-temperature curability.

One of these compounds may be used singly, or two or more thereof may be used in combination.

Examples of the aromatic amine compound include, but are not limited to, aniline, toluidine, benzylamine, naphthylamine, diaminodiphenylmethane, and diaminodiphenylsulfone,

Examples of the guanidine compound include, but are not limited to, dicyandiamide, methylguanidine, ethylguanidine, propylguanidine, butylguanidine, dimethylguanidine, trimethylguanidine, phenylguanidine, diphenylguanidine, and toluylguanidine. One of these compounds may be used singly, or two or more thereof may be used in combination.

Examples of the imidazole compound except for the compounds of the formula (1) and the formula (2) include, but are not limited to, imidazole, 2-methylimidazole, 4-methylimidazole, 2-ethyl-4-methylimidazole, 2-undecylimidazole, 2-heptadecylimidazole, 2-phenylimidazole, 1-benzyl-2-phenylimidazole, 1-aminoethyl-2-methylimidazole, 1-(2-hydroxy-3-phenoxypropyl)-2-methylimidazole, 1-(2-hydroxy-3-phenoxypropyl)-2-ethyl-4-methylimidazole, 1-(2-hydroxy-3-butoxypropyl)-2-methylimidazole, and 1-(2-hydroxy-3-butoxypropyl)-2-ethyl-4-methylimidazole.

One of these compounds may be used singly, or two or more thereof may be used in combination.

Examples of the diluent include, but are not limited to, dioctyl phthalate, dibutyl phthalate, and benzyl alcohol.

The reactive diluent is a compound having a reactive functional group capable of being integrated into a curing structure such as an epoxy group or an acrylic group, and is a compound effective for reducing the viscosity of the epoxy resin composition of the present embodiment by addition into the epoxy resin composition.

Examples of the reactive diluent include, but are not limited to, acrylate compounds and epoxy compounds capable of reducing a viscosity without impairing reactivity.

Examples of the acrylate compound serving as the reactive diluent include, but are not limited to, compounds having (meth)acryloyl groups at both ends of polyalkylene oxide, polyethylene glycol di(meth)acrylate, polypropylene glycol di(meth)acrylate, polybutylene glycol di(meth)acrylate, trimethylolpropane-type polyfunctional (meth)acrylate, pentaerythritol-type polyfunctional (meth)acrylate, and dipentaerythritol-type polyfunctional (meth)acrylate.

Examples of the epoxy compound serving as the reactive diluent include, but are not limited to, n-butyl glycidyl ether, tert-butyl glycidyl ether, diglycidyl aniline, N,N'-glycidyl-o-toluidine, phenyl glycidyl ether, cresyl glycidyl ether, p-tert-butyl phenyl glycidyl ether, styrene oxide, ethylene glycol diglycidyl ether, propylene glycol diglycidyl ether, and 1,6-hexanediol diglycidyl ether.

The reactive diluent is preferably a compound containing two or more glycidyl groups in one molecule from the viewpoint of being able to form a three-dimensional cross-link at the time of curing and suppressing reduction in heat resistance or toughness at the time of curing.

One of these reactive diluents may be used singly, or two or more thereof may be used in combination.

The content of the reactive diluent can be appropriately set depending on desired performance and is not particularly limited. The content is preferably 1.0 part by mass or more and 30 parts by mass or less with respect to 100 parts by mass of the epoxy resin (a). The content is 1.0 part by mass or more, whereby the viscosity of the epoxy resin composition of the present embodiment is prevented from being elevated at ordinary temperature, and deterioration in embedding properties tends to be able to be suppressed upon use as a film for wiring embedding. Furthermore, reduction in heat resistance or toughness is suppressed at the time of curing, and the generation and progression of fillet cracks tend to be suppressed. On the other hand, the content of the reactive diluent is 30 parts by mass or less with respect to 100 parts by mass of the epoxy resin (a), whereby reduction in close contact is suppressed, and peeling tends to be suppressed at the time of a moisture reflow test. It is also preferred to further contain the reactive diluent for the purpose of suppressing elevation in viscosity resulting from high filling of the filler (d).

Examples of the pigment include, but are not limited to, kaolin, chalk powders, gypsum, antimony trioxide, penton, aerosol, lithopone, baryte, and titanium dioxide.

Examples of the dye include, but are not limited to, natural dyes including plant-derived dyes such as madder and indigo, and mineral-derived dyes such as ocher and bole, and synthetic dyes such as alizarin and indigo as well as fluorescent dyes.

Examples of the flow adjuster include, but are not limited to: organic titanium compounds such as titanium tetraisopropoxide and titanium diisopropoxy bis(acetylacetonate); and organic zirconium compounds such as zirconium tetra-normal butoxide and zirconium tetraacetylacetonate.

Examples of the thickener include, but are not limited to: animal-derived thickeners such as gelatin; plant-derived thickeners such as polysaccharides and cellulose; and chemical synthetic thickeners such as polyacrylic thickeners, modified polyacrylic thickeners, polyether-based thickeners, urethane-modified polyether-based thickeners, and carboxymethylcellulose.

Examples of the reinforcing agent include, but are not limited to: polyethylene sulfone powders such as "SUMIKAEXCEL PES" manufactured by Sumitomo Chemical Co., Ltd.; and silicone-based reinforcing agents such as functional group-modified core-shell rubber nanoparticles (e.g., "KANEACE MX" manufactured by Kaneka Corp.) and polyorganosiloxane.

Examples of the mold release agent include, but are not limited to, fluorine-based mold release agents, silicone-based mold release agents, and acrylic mold release agents composed of copolymers of glycidyl (meth)acrylate and linear alkyl (meth)acrylate having 16 to 22 carbon atoms.

Examples of the wetting agent include, but are not limited to, unsaturated polyester copolymer-based wetting agents having an acidic group, such as acrylic polyphosphoric acid ester.

Examples of the flame retardant include, but are not limited to, bromine-based flame retardants, phosphorus-based flame retardants, and inorganic flame retardants.

Examples of the bromine-based flame retardant include, but are not particularly limited to, tetrabromophenol.

Examples of the phosphorus-based flame retardant include, but are not particularly limited to, 9,10-dihydro-9-oxa-10-phosphaphenanthrene-10-oxide and its epoxy derivatives, triphenylphosphine and its derivatives, phosphoric acid ester, condensed phosphoric acid ester, and phosphazene compounds.

Examples of the nitrogen flame retardant include, but are not particularly limited to, melamine polyphosphate, isocyanuric acid, guanidine-based flame retardants, and triazine-based flame retardants.

Examples of the inorganic flame retardant compound include, but are not particularly limited to, magnesium hydroxide and aluminum hydroxide.

A phosphazene compound or magnesium hydroxide is preferred from the viewpoint of heat resistance. A phosphazene compound disclosed in Japanese Patent No. 723041 may be used.

One of these flame retardants may be used singly, or two or more thereof may be used in combination.

The content of the flame retardant is not particularly limited and is preferably 5.0 parts by mass or more and 200 parts by mass or less, more preferably 10 parts by mass or more and 100 parts by mass or less, with respect to the mass (100 parts by mass) of the epoxy resin (a).

Examples of the surfactant include, but are not limited to, anionic surfactants such as alkyl benzenesulfonate and alkyl polyoxyethylene sulfate, cationic surfactants such as alkyl dimethylammonium salt, amphoteric surfactants such as alkyldimethylamine oxide and alkylcarboxybetaine, and nonionic surfactants such as linear alcohols having 25 or more carbon atoms and fatty acid ester.

A compound that improves the storage stability of the epoxy resin composition can be used as the stabilizer. Examples thereof include, but are not limited to, boric acid, cyclic boric acid ester compounds, isocyanuric acid, barbituric acid, and aluminum chelating agents. The cyclic boric acid ester compound contains boric acid in a cyclic structure. The cyclic boric acid ester compound is preferably 2,2'-oxybis(5,5'-dimethyl-1,3,2-oxaborinane) from the viewpoint of compatibility with a resin and uniform curability.

One of these stabilizers may be used singly, or two or more thereof may be used in combination.

Components can be widely used as the adhesion promoter as long as the components are added for the purpose of forming a coordination bond with a metal or a substrate material or improving affinity. A thiazole compound or a triazole compound is preferred from the viewpoint of further obtaining an effect of forming a favorable film on adherend surface and enhancing close contact.

The solvent is not particularly limited, and a known solvent can be used. Examples thereof include, but are not limited to: hydrocarbons such as benzene, toluene, xylene, cyclohexane, mineral spirits, and solvent naphtha, ketones such as acetone, methyl ethyl ketone (MEK), methyl isopropyl ketone, methyl isobutyl ketone, cyclohexanone, and acetophenone; esters such as ethyl acetate, n-butyl acetate, propylene glycol monomethyl ethyl ether acetate, and γ-butyrolactone; alcohols such as methanol, ethanol, isopropanol, n-butanol, butyl cellosolve, butyl carbitol, 2-phenoxyethanol, and 1-methoxy-2-propanol; and amide-based solvents such as dimethylformamide, dimethylacetamide, and N-methylpyrrolidone.

One of these solvents may be used singly, or two or more thereof may be used in combination.

The content of the solvent in the epoxy resin composition of the present embodiment is not particularly limited. In the case of blending the solvent therewith for use as a varnish or a paste, the content is preferably 5 to 80% by mass, more preferably 10 to 75% by mass, further preferably 15 to 70% by mass, still further preferably 20 to 65% by mass, even further preferably 25 to 60% by mass, with respect to the whole epoxy resin composition from the viewpoint of attaining favorable handleability by uniformly dissolving various components and controlling a viscosity to a proper range.

When other components contain a solvent, the content also includes such a solvent and is in a preferred range of the proportion of the solvent in the whole epoxy resin composition.

In the case of preparing the epoxy resin composition of the present embodiment into a film, the content of the solvent in an epoxy resin composition layer after drying for the removal of the solvent is not particularly limited and is preferably 8% by mass or less, more preferably 5% by mass or less, further preferably 3% by mass or less, with respect to the whole epoxy resin composition from the viewpoint of suppressing air bubble formation. On the other hand, the content is preferably 0.0001% by mass or more, more preferably 0.001% by mass or more, further preferably 0.01% by mass or more, with respect to the whole epoxy resin composition from the viewpoint of controlling a favorable viscosity at the time of film lamination.

The amount of the aforementioned additive added can be a functionally equivalent amount. For example, the pigment and/or the dye is added in an amount that can offer a desired color to the epoxy resin composition of the present embodiment. Those skilled in the art can appropriately set a proper amount of the additive added depending on the contents of formulation or desired performance.

### [Method for producing epoxy resin composition]

The epoxy resin composition of the present embodiment contains the components (a) to (c) mentioned above and are obtained by mixing these components, if necessary, with the components (d) to (g) and the additive mentioned above.

The mixing method is not particularly limited, and a method known to those skilled in the art can be applied thereto. The epoxy resin composition or the resin paste can be obtained by thoroughly mixing the components until homogeneous using, for example, but not limited to, a mixing roll such as triple rolls, a dissolver, a planetary mixer, a rotary mixer, a kneader, or an extruder.

### [Specific aspects of epoxy resin composition]

The epoxy resin composition of the present embodiment causes little warpage of a cured product of the epoxy resin composition and is excellent in cured product strength and adhesion strength to a metal adherend, and as such, can be used as a sealing material for electric and electronic components, such as an underfill and a relay sealing material, various insulating liquid adhesives, a paste material for die attach pastes, conductive pastes, thermally conductive pastes, and the like, an ink material for solder resist ink, hole-plugging ink, and the like, a matrix resin for fiber-reinforced plastics, or an impregnant fixative for motor coils.

### [Film having resin layer made of epoxy resin composition]

The epoxy resin composition of the present embodiment can be prepared into a film having a resin layer made of the epoxy resin composition of the present embodiment.

The film of the present embodiment has, for example, a predetermined support and a resin layer formed from the epoxy resin composition mentioned above on the support and may have, if necessary, a protective layer on the surface, opposite to the support, of the resin layer.

### (Support)

The support constituting the film is preferably a material that resists a temperature at the time of solvent drying.

Examples of such a support include, but are not limited to, polyethylene terephthalate films, polyvinyl alcohol films, polyvinyl chloride films, vinyl chloride copolymer films, polyvinylidene chloride films, vinylidene chloride copolymer films, methyl polymethacrylate copolymer films, polystyrene films, polyacrylonitrile films, styrene copolymer films, polyamide films, and cellulose derivative films.

These films may be drawn, if necessary, for use.

### (Protective layer)

The protective layer is preferably a material that can sufficiently maintain the surface smoothness of the resin layer constituting the film.

Such a protective layer is not limited, and, a polyethylene film, a polypropylene film, a polyethylene terephthalate film treated for easy peeling, an oriented polypropylene film, or the like can be preferably used.

### (Method for producing film having epoxy resin composition layer)

The film of the present embodiment can be produced by sequentially laminating the support and the resin layer and, if necessary, the protective layer.

A known method can be adopted as a method for laminating the support, the resin layer, and the protective layer.

For example, the epoxy resin composition of the present embodiment supplemented with the aforementioned solvent is prepared. First, a support is coated therewith by use of a known method such as an applicator, a bar coater, a lip coater, a die coater, a roll coater, or a doctor blade coater, and dried to form an epoxy resin layer on the support. Examples of the drying method include, but are not particularly limited to, ovens and blasting of hot air. The drying temperature or time is not particularly limited. The drying is preferably performed within a temperature range of 50°C to 160°C and within a drying time of 1 minute to 30 minutes and more preferably performed at 80°C to 150°C for 3 minutes to 25 minutes, from the viewpoint of suppressing the deformation of the support by excessive heating and extra reaction of the resin layer at the time of drying while thoroughly removing the solvent. The drying temperature may be a constant temperature or may have a temperature gradient. Subsequently, a protective layer can be laminated, if necessary, onto the formed resin layer to produce the film of the present embodiment.

### (Specific aspect of film of present embodiment)

The film of the present embodiment can be used as, for example, but not limited to, an interlayer insulating film, a film-type solder resist, a sealing sheet for a semiconductor package, a die attach film, a conductive film, an anisotropically conductive film, a nonconductive film, or a thermally conductive film.

The epoxy resin composition layer of the present embodiment reduces the warpage of a base material having a cured product of the epoxy resin composition of the present embodiment and is excellent in cured product strength and adhesion strength to a metal adherend, and as such is suitable for purposes of films that are susceptible to warpage of a substrate having a cured product, are required to have high strength and reliability in a thin cured layer portion, and require strong adhesion to a metal adherend. A film obtained using the epoxy resin composition of the present embodiment has excellent preservation stability, which is also a suitable factor for purposes of films.

These characteristics are required in common for interlayer insulating films, film-type solder resists, sealing sheets for semiconductor packages, die attach films, conductive films, anisotropically conductive films, nonconductive films, and thermally conductive films. Therefore, the film-type adhesive of the present embodiment is suitable for these aspects.

### [Printed wiring board]

The printed wiring board of the present embodiment has a cured product layer of the epoxy resin composition of the present embodiment.

In the case of producing the printed wiring board using the film of the present embodiment mentioned above, the film produced by the method described above is laminated with a patterned inner-layer circuit substrate, and pressurized and heated from the support side for lamination. The surface of the inner-layer circuit may be treated by roughening. The lamination is preferably batch lamination or continuous lamination in rolls under ordinary pressure or reduced pressure, or simultaneous lamination on both sides. In this respect, the lamination conditions preferably involve a pressure bonding temperature of 70°C to 150°C and a pressure bonding pressure of 0.1 to 1 MPa. It is preferred for preventing voids to perform lamination under reduced pressure of 2 Kpa or lower. The laminate thus obtained is cooled to room temperature. After that, the support film is peeled. Then, the adhesive film laminated on the inner-layer circuit substrate is cured by heating to form a cured product layer. The curing conditions preferably involve a curing temperature of 130 to 200°C and a curing time within the range of 30 minutes to 120 minutes.

Next, a location that becomes a via hole is punched with laser such as carbon dioxide laser and treated by roughening with an oxidizing agent such as permanganate, bichromate, or ozone for the purpose of removing smear and improving close contact with plating. Then, a conductor circuit is selectively formed on the cured product layer by electroless plating or electrolytic plating, and at the same time therewith, a conductor is formed on the inner wall of the via hole to form an outer-layer circuit. Then, the close contact of the conductor layer with the resin layer can be improved by annealing treatment at 150 to 200°C for 30 minutes to 60 minutes. Multiple buildup layers can be further formed on the conductor circuit layer thus obtained by repeating the production method described above using the film of the present embodiment, to produce a printed wiring board.

The cured product of the epoxy resin composition of the present embodiment causes little warpage and is excellent in cured product strength and adhesion strength to a metal adherend, and as such, can be used in a wide range of printed wiring boards such as rigid substrates, flexible substrates, one-sided laminating substrates, and thin substrates and can be suitably used, particularly, as a buildup layer for multilayer printed wiring boards.

### [Semiconductor chip package]

The semiconductor chip package of the present embodiment has a cured product layer of the epoxy resin composition of the present embodiment.

A semiconductor chip package excellent in low warpage of a substrate and strength can be prepared by using the film having the resin layer made of the epoxy resin composition of the present embodiment mentioned above. The film-type adhesive of the present embodiment can be suitably used, particularly, in wafer-level packages or panel-level packages for which low warpage of a substrate is important because a substrate having a large area is used. The film of the present embodiment may be laminated on both sides of a substrate or may be laminated on one side thereof. Various methods for producing packages have been contrived, and the packages can be largely divided into a fan-in structure and a fan-out structure.

In the case of producing a semiconductor chip package having a fan-in structure using the film of the present embodiment produced as described above, for example, the film produced by the method described above is laminated onto a substrate such as a silicon wafer with a circuit, a device, and an electrode pad formed thereon, and cured to obtain a cured product layer. In this respect, the lamination conditions and the curing conditions may be the same as those in producing the printed wiring board or may be appropriately changed depending on the heat resistance or the like of the device used.

Subsequently, a rewiring layer is formed on the cured product layer by punching treatment, smear removal, electroless plating, and electrolytic plating to obtain a circuit layer. A multilayer circuit can be further formed, if necessary, by repeating lamination and circuit layer formation. Then, a solder ball is placed so as to assume conduction with the circuit layer, and the resultant can be singulated by dicing to produce the package having a fan-in structure according to the present invention.

The circuit layer may be formed by forming a columnar electrode on the electrode pad before lamination of the film of the present embodiment onto the substrate, curing the epoxy resin composition layer, and then polishing the upper surface of the cured layer until the columnar electrode surface is exposed.

In the case of producing a semiconductor package having a fan-out structure using the film of the present embodiment produced as described above, for example, a substrate such as a silicon wafer is singulated by dicing, and the individual dies are rearranged and fixed onto a support via a film such as a die attach film. Then, the film of the present embodiment is laminated from the die side and cured to form a cured product layer.

Subsequently, a rewiring layer is formed on the cured product layer by punching treatment, smear removal, electroless plating, and electrolytic plating to obtain a circuit layer. A multilayer circuit can be further formed, if necessary, by repeating lamination and circuit layer formation. Then, a solder ball can be placed so as to assume conduction with the circuit layer to produce a package having a fan-out structure.

A circuit, a device, and an electrode pad may be formed in advance before dicing of the substrate. In this case, after formation of the cured product layer by rearrangement, an opening is formed in the electrode pad moiety by etching treatment, and a circuit layer can be formed within the opening. Then, a circuit pattern and an electrode are formed on the cured product layer using a photoresist material, and a solder ball can also be placed so as to assume conduction with the circuit to produce a semiconductor package having a fan-out structure.

### [Electronic device]

The electronic device of the present embodiment has the printed wiring board and/or the semiconductor chip package of the present embodiment mentioned above.

The printed wiring board or the semiconductor chip package of the present embodiment has a cured product layer having low warpage, high strength, and excellent adhesion to a metal adherend and therefore prevents poor connection or cracks ascribable to warpage, when mounted to a finer, smaller, and higher-density electronic device. Therefore, the resulting electronic device is excellent in long-term reliability and thus preferable.

The electronic device is not particularly limited as long as the device functions by integration into electronic components. Examples thereof include various electronic devices for use in electronics such as personal computers, smart phones, gaming consoles, digital cameras, and televisions, vehicles such as motorcycles, automobiles, trains, ships, and aircrafts, and antennas and servers for high-speed communications, etc.

The electronic device of the present embodiment can be produced by mounting various semiconductor chips to locations where the circuit connection of the printed wiring board is performed so as to create conduction.

Specific examples of the method for mounting the semiconductor chip in producing the electronic device include, but are not particularly limited to, wire bonding mounting methods, flip chip mounting methods, mounting methods using bumpless buildup layers (BBUL), mounting methods using anisotropically conductive films, and mounting methods using nonconductive films.

For mounting, the semiconductor chip may be subjected to sealing, adhesion, and the like using the epoxy resin composition of the present embodiment or the film.

### Examples

Hereinafter, the present embodiment will be described with reference to specific Examples and Comparative Examples. However, the present invention is not limited by Examples and Comparative Examples given below and may be appropriately changed or modified without departing from the spirit of the invention.

### [Preparation of epoxy resin composition]

Various components were each weighed into parts by mass of blending shown in Table 1 described below, and mixed.

The parts shown in Table 1 described below are the amounts of involatile components except for a solvent when the solvent is contained in each starting material.

For example, when Table 1 described below shows 30 (parts by mass) as to e-1: HPC-8000-65T (toluene solution having a solid content of 65% by mass of an active ester-based curing agent, active group equivalent: 223 g/eq, manufactured by DIC Corp.), this refers to the amount of involatile components and means that 46.15 parts by mass including a solvent were added.

Subsequently, a solvent adjusted to methyl ethyl ketone:cyclohexane = 1:1 was added such that the proportion of involatile components was 65% by mass. The blend was mixed by stirring for 3 minutes and defoaming for 2 minutes with a non-bubbling kneader placed in an environment of 25°C to obtain an epoxy resin composition for coating. In this respect, the amount of the solvent added was determined such that the proportion of involatile components was 65% by mass including the amount of the solvent brought in from the starting material.

### [Evaluation method]

### (Evaluation of warpage: measurement of warpage level)

A central portion of aluminum foil having a length of 15 cm, a width of 8 cm, and a thickness of 1.7 mm was coated with the epoxy resin composition for coating at a length of 12 cm, a width of 5 cm, and a dry film thickness of 150 µm, and then dried by heating for 5 minutes in an oven preheated to 120°C to obtain aluminum foil having an epoxy resin composition layer.

The aluminum foil thus dried was allowed to cool to room temperature and then cured for 1 hour in an oven of 180°C with four corners fixed by heat-resistant tapes to obtain aluminum foil having a cured product layer of the epoxy resin composition.

The end portion on one side in the longitudinal direction of the aluminum foil having the cured product layer was fixed to a flat surface, and the height of rising of the aluminum foil end portion from the flat surface was measured as to the end portion on the other side of the aluminum foil and regarded as a warpage level. Evaluation was made according to the following criteria depending on the warpage level.

### <Evaluation criteria>

Warpage level:
≤ 5 mm ... ○
5 mm < warpage level ≤ 25 mm ... △
25 mm < warpage level ... ×

### (Evaluation of strength of cured product: measurement of tensile strength of cured product layer)

A cured product of the epoxy resin composition was evaluated by the method described in the evaluation of warpage. Then, the aluminum foil was peeled to isolate the cured product layer.

The isolated cured product layer was cut into a width of 5 mm and a length of 4 cm to obtain a test specimen.

The cut test specimen was subjected to a tensile test (AUTOGRAPH AGS-X 5kN, manufactured by Shimadzu Corp.) at a tensile rate of 100 mm/min in a constant temperature and humidity room of 23°C and 50% RH to measure the tensile strength of the cured product layer.

Evaluation was made according to the following criteria depending on the tensile strength.

### <Evaluation criteria>

Tensile strength of cured product layer:
40 MPa or more ... ○
20 MPa or more and less than 40 MPa ... △
Less than 20 MPa ... ×

### (Evaluation of adhesion strength to metal adherend: measurement of copper plate shear adhesion strength)

A polyethylene terephthalate film (thickness: 50 µm) serving as a support was coated with the epoxy resin composition at a dry film thickness of 40 µm.

Then, the film was dried by heating for 5 minutes in an oven preheated to 120°C. Then, the surface opposite to the support was protected with a polyethylene terephthalate film treated for easy peeling to obtain a film having an epoxy resin composition layer.

The film was cut into a size of 25 mm × 5 mm, and the protective film was peeled. Then, the resulting film, together with the support, was placed and fixed between two copper plates (manufactured by Standard Test Piece Co., Ltd., "C1100P"). In this state, the film material was transferred to the copper plates by heating for 10 minutes in an oven of 60°C, followed by the peeling of the support.

Subsequently, the epoxy resin composition layer was sandwiched between two copper plates again and in this state, heat-cured and allowed to adhere thereto by heating for 1 hour in an oven preheated to 180°C to obtain a test specimen.

The obtained test specimen was subjected to a tensile test (AUTOGRAPH AGS-X 5kN, manufactured by Shimadzu Corp.) at a tensile rate of 5 mm/min in a constant temperature and humidity room of 23°C and 50% RH to measure shear adhesion strength (MPa). Evaluation was made according to the following criteria depending on the shear adhesion strength.

### <Evaluation criteria>

Shear adhesion strength:
15 MPa or more ... ○
12 MPa or more and less than 15 MPa ... △
Less than 12 MPa ... ×

### (Evaluation of film preservation stability: DSC measurement of change in total quantity of heat generated between before and after film storage)

A film having an epoxy resin composition layer was prepared by the method described in the section (Evaluation of adhesion strength to metal adherend). Approximately 10 mg of the epoxy resin composition layer was heated from 25°C to 250°C at a temperature increase rate of 10°C/min using a differential scanning calorimeter EXSTER7020 (manufactured by Hitachi High-Tech Science Corp.), and the total quantity of heat generated was calculated from the obtained differential scanning calorimetry curve (DSC curve) and regarded as an initial total quantity of heat generated from the epoxy resin layer.

Subsequently, the prepared film having the epoxy resin composition layer was stored for 3 days in an oven of 40°C. The total quantity of heat generated from the epoxy resin composition layer thus stored was calculated by the same measurement method as above and regarded as a total quantity of heat generated from the stored epoxy resin layer.

The rate of retention of the total quantity of heat generated was calculated according to the following expression. 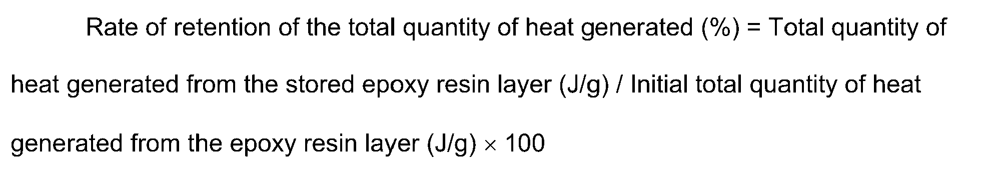 Rate of retention of the total quantity of heat generated (%) = Total quantity of heat generated from the stored epoxy resin layer (J/g) / Initial total quantity of heat generated from the epoxy resin layer (J/g) × 100

The rate of retention of the total quantity of heat generated was evaluated according to the following criteria.

### <Evaluation criteria>

Rate of retention of total quantity of heat generated
95% or more ... ○
90% or more and less than 95% ... △
Less than 90% ... ×

### [Component of epoxy resin composition]

Hereinafter, each component in Table 1 described below will be shown as a component used in the epoxy resin compositions of Examples and Comparative Examples.

### (Component (a): epoxy resin)

a-1: EXA850CRP (BisA-type liquid epoxy resin, epoxy equivalent: 190 g/eq, manufactured by DIC Corp.)
a-2: EXA830CRP (BisF-type liquid epoxy resin, epoxy equivalent: 160 g/eq, manufactured by DIC Corp.)
a-3: HP4032D (naphthalene-type liquid epoxy resin, epoxy equivalent: 142 g/eq, manufactured by DIC Corp.)
a-4: NC-3000 (biphenyl-type solid epoxy resin, epoxy equivalent: 275 g/eq, manufactured by Nippon Kayaku Co., Ltd.)
a-5: YX4000 (biphenyl-type solid epoxy resin, epoxy equivalent: 186 g/eq, manufactured by Mitsubishi Chemical Group Corp.)

### (Component (b): compound represented by formula (1))

b-1: 2-[[2-(2-Hydroxyphenyl)-1H-benzimidazol-1-yl]methyl]phenol produced by the following method.

To 100 mL of dimethylformamide, 15.2 parts by mass of N,N'-bis(salicylidene)-1,2-phenylenediamine, 9.5 parts by mass of sodium disulfite, and 0.2 parts by mass of water were added, and the mixture was reacted at 80°C for 4 hours and then purified by silica gel column chromatography to obtain compound b-1. The compound b-1 was confirmed by LC-MS/MS to be 2-[[2-(2-hydroxyphenyl)-1H-benzimidazol-1-yl]methyl]phenol.

### (Component (c): compound represented by formula (2))

c-1: 2-(2-Hydroxyphenyl)benzimidazole (manufactured by Tokyo Chemical Industry Co., Ltd.)

### (Component (d): filler)

d-1: SO-E2 (spherical silica filler, average particle size: 0.5 µm, manufactured by Admatechs Co., Ltd.)

### (Component (e): predetermined curing agent)

e-1: HPC-8000-65T (toluene solution having a solid content of 65% of an active ester-based curing agent, active group equivalent: 223 g/eq, manufactured by DIC Corp.)

e-2: LA-3018-50P (1-methoxy-2-propanol solution having a solid content of 50% of a triazine skeleton-containing phenol-based curing agent, OH group equivalent: 151 g/eq, manufactured by DIC Corp.)

### (Component (f): polymer)

f-1: PKHB (phenoxy resin, weight-average molecular weight: 32000, manufactured by Gabriel Phenoxies)

### (Component (g): silane coupling agent)

g-1: KBM-573 (aminosilane-based coupling agent, manufactured by Shin-Etsu Chemical Co., Ltd.)

### (Other components)

r-1: 1B2PZ (1-benzyl-2-phenylimidazole, manufactured by Shikoku Kasei Holdings Corp.)

### [Examples 1 to 7] and [Comparative Examples 1 to 2]

Components were blended at the proportions (parts by mass) shown in Table 1, and each epoxy resin composition was prepared by the method described above.

Each characteristic of the prepared epoxy resin composition was evaluated by the method described above.

**[Table 1]**

| Component (parts by mass) | Example 1 | Example 2 | Example 3 | Example 4 | Example 5 | Example 6 | Example 7 | Comparative Example 1 | Comparative Example 2 |
|---|---|---|---|---|---|---|---|---|---|
| a-1 | 5 | 5 | 5 | 5 | 5 | 5 | 5 | 5 | 5 |
| a-2 | 5 | 5 | 5 | 5 | 5 | 5 | 5 | 5 | 5 |
| a-3 | 5 | 5 | 5 | 5 | 5 | 5 | 5 | 5 | 5 |
| a-4 | 30 | 30 | 30 | 30 | 30 | 30 | 30 | 30 | 30 |
| a-5 | 10 | 10 | 10 | 10 | 10 | 10 | 10 | 10 | 10 |
| b-1 | 0.15 | 0.03 | 0.15 | 0.03 | 0.15 | 0.0001 | 0.75 | | |
| c-1 | 1 | 1 | 3 | 3 | 1 | 10 | 3 | 1 | |
| d-1 | 220 | 220 | 220 | 220 | 100 | 100 | 100 | 220 | 220 |
| e-1 | 30 | 30 | 30 | 30 | 30 | 30 | 30 | 30 | 30 |
| e-2 | 10 | 10 | 10 | 10 | 10 | 10 | 10 | 10 | 10 |
| f-1 | 5 | 5 | 5 | 5 | 5 | 5 | 5 | 5 | 5 |
| g-1 | 2.2 | 2.2 | 2.2 | 2.2 | 1 | 1 | 1 | 2.2 | 2.2 |
| r-1 | | | | | | | | | 1 |
| Total amount of involatile component | 323.35 | 323.23 | 325.35 | 325.23 | 202.15 | 211.0001 | 204.75 | 323.2 | 323.2 |
| Warpage | ○ | ○ | ○ | ○ | ○ | ○ | ○ | ○ | × |
| Tensile strength of cured product layer | ○ | ○ | ○ | ○ | ○ | ○ | ○ | Δ | × |
| Copper plate shear adhesion strength | ○ | ○ | ○ | ○ | ○ | ○ | ○ | × | × |
| Film preservation stability | ○ | ○ | ○ | ○ | ○ | Δ | ○ | Δ | × |

When Example 1 and Comparative Example 1 were compared, a sample containing the component b-1 was excellent in tensile strength of the cured product layer and copper plate shear adhesion strength and was found excellent in film preservation stability when prepared into a film.

When Example 1 and Comparative Example 2 were compared, a sample containing the components b-1 and c-1 was able to confer much better low warpage, tensile strength of the cured product layer, and copper plate shear adhesion strength and was further found able to confer even film preservation stability when prepared into a film.

The present application is based on Japanese Patent Application No. 2023-189603 filed in the Japan Patent Office on November 6, 2023, the contents of which are incorporated herein by reference.

### Industrial Applicability

The epoxy resin composition of the present embodiment is excellent in low warpage, tensile strength of a cured product layer, and copper plate shear adhesion strength and also excellent in film preservation stability when prepared into a film, and as such, has industrial applicability in the fields of resin materials including sealing materials for electric and electronic components, such as underfills and relay sealing materials, various insulating liquid adhesives, paste materials for die attach pastes, conductive pastes, thermally conductive pastes, and the like, ink materials for solder resist ink, hole-plugging ink, and the like, matrix resins for fiber-reinforced plastics, and impregnant fixatives for motor coils, and film materials for interlayer insulating films, film-type solder resists, sealing sheets for semiconductor packages, die attach films, conductive films, anisotropically conductive films, nonconductive films, thermally conductive films, and the like.

Particularly, multilayer printed wiring boards, coreless substrates, and large-package substrates for high-speed servers or network servers, for example, are required to have lower warpage and higher strength. Therefore, for example, the film, the printed wiring board, the semiconductor chip package, and the electronic device of the present invention can be effectively utilized therein.

## Claims

1. A composition comprising
(b): a compound represented by the following formula (1), and
(c): a compound represented by the following formula (2) (except for the compound represented by the formula (1)): 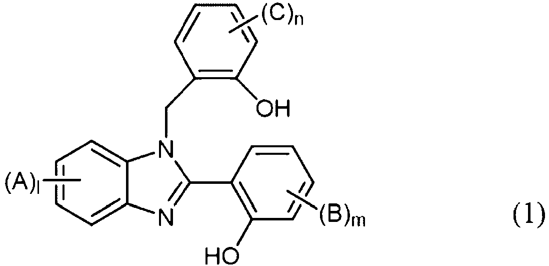 wherein
each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4, 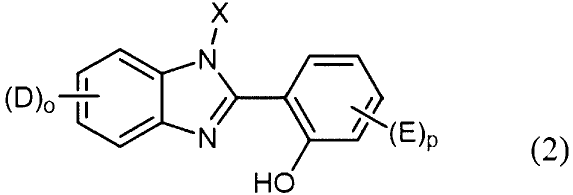 wherein
X is any one member selected from the group consisting of a hydrogen atom, an alkyl group having 1 to 20 carbon atoms and optionally having a substituent, an alkenyl group having 2 to 20 carbon atoms and optionally having a substituent, an aralkyl group having 7 to 20 carbon atoms and optionally having a substituent, and a heteroarylalkyl group having 4 to 20 carbon atoms and optionally having a substituent;
each of D and E is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, D and E are the same as or different from each other, and two or more D moieties or two or more E moieties are optionally bonded to each other to form a monocyclic ring or a condensed ring; and
each of o and p is an integer of 1 to 4.

2. The composition according to claim 1, wherein the composition is a curing agent.

3. The composition according to claim 1, wherein
a mass ratio between (b): the compound represented by the formula (1) and (c): the compound represented by the formula (2) (except for the compound represented by the formula (1)) is (b):(c) = 0.001:100 to 20:80.

4. The composition according to claim 1, wherein the composition is an adhesion promoter.

5. The composition according to claim 1, wherein
in (b): the compound represented by the formula (1),
each of A, B, and C is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

6. The composition according to claim 1, wherein
in (c): the compound represented by the formula (2),
X is a hydrogen atom, and each of D and E is one member selected from the group consisting of a hydrogen atom, a hydroxy group, a carboxy group, an alkoxy group having 1 to 20 carbon atoms and having no substituent, an alkyl group having 1 to 20 carbon atoms and having a hydroxy group and/or a carboxy group as a substituent, an aryl group having 6 to 20 carbon atoms and having a hydroxy group and/or a carboxy group as a substituent, an aryloxy group having 6 to 20 carbon atoms and having a hydroxy group and/or a carboxy group as a substituent, and an acyl group having 1 to 20 carbon atoms and having a hydroxy group and/or a carboxy group as a substituent.

7. The composition according to claim 1, comprising,
as (b): the compound represented by the formula (1),
any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol.

8. The composition according to claim 1, comprising,
as (c): the compound represented by the formula (2),
any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid.

9. An epoxy resin composition comprising
the composition according to claim 1, and
(a): an epoxy resin.

10. An epoxy resin composition comprising
(b): a compound represented by the formula (1), and
(a): an epoxy resin: 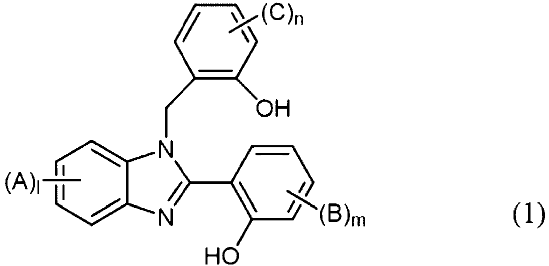 wherein
each of A, B, and C is any one member selected from the group consisting of a hydrogen atom, a halogen atom, a hydroxy group, a carboxy group, a cyano group, a nitro group, an alkyl group having 1 to 20 carbon atoms and optionally having a substituent, an alkoxy group having 1 to 20 carbon atoms and optionally having a substituent, an alkenyl group having 2 to 20 carbon atoms and optionally having a substituent, an aryl group having 6 to 20 carbon atoms and optionally having a substituent, an aryloxy group having 6 to 20 carbon atoms and optionally having a substituent, and an acyl group having 1 to 20 carbon atoms and optionally having a substituent, A, B, and C are the same as or different from each other, and two or more A moieties, two or more B moieties, or two or more C moieties are optionally bonded to each other to form a monocyclic ring or a condensed ring; and each of I, m, and n is an integer of 1 to 4.

11. An epoxy resin composition comprising
the composition according to claim 7, and
(a): an epoxy resin.

12. The epoxy resin composition according to claim 9, further comprising (d): a filler.

13. The epoxy resin composition according to claim 9, further comprising (e): at least one member selected from the group consisting of a phenol compound, an active ester compound, and a cyanate ester compound.

14. The epoxy resin composition according to claim 9, further comprising (f): a polymer (except for the component (a) and the component (e)).

15. The epoxy resin composition according to claim 9, further comprising (g): a silane coupling agent.

16. The epoxy resin composition according to claim 9, comprising
as (b): the compound represented by the formula (1),
any member selected from the group consisting of 2-[[2-(2-hydroxyphenyl)-1H-benzimidazol-1-yl]methyl]phenol, 2-[[2-(2-hydroxy-3-methoxyphenyl)-1H-benzimidazol-1-yl]methyl]-6-methoxyphenol, 2-[[2-(2-hydroxy-1-naphthalenyl)-1H-benzimidazol-1-yl]methyl]-1-naphthalenol, and 3-[[2-(2,3-dihydroxyphenyl)-1H-benzimidazol-1-yl]methyl]-1,2-benzenediol, and
as (c): the compound represented by the formula (2),
any member selected from the group consisting of 2-(2-hydroxyphenyl)benzimidazole, 2-(2-hydroxy-3(5)-methoxyphenyl)benzimidazole, 2-(1-hydroxynaphthalen-2-yl)benzimidazole, 2-(2-hydroxynaphthalen-1-yl)benzimidazole, and 2-(2-hydroxyphenyl)benzimidazole-6-carboxylic acid, wherein
a mass ratio between the component (b) and the component (c) is (b):(c) = 0.001:100 to 20:80, and
further comprising
(d): a filler,
(e): at least one member selected from the group consisting of a phenol compound, an active ester compound, and a cyanate ester compound,
(f): a polymer (except for the component (a) and the component (e)), and
(g): a silane coupling agent.

17. A film having
a support, and
a resin layer comprising the epoxy resin composition according to any one of claims 9 to 16 on the support.

18. A printed wiring board having
a cured product layer of the epoxy resin composition according to any one of claims 9 to 16.

19. A semiconductor chip package having
a cured product layer of the epoxy resin composition according to any one of claims 9 to 16.

20. An electronic device having the printed wiring board according to claim 18.

21. An electronic device having the semiconductor chip package according to claim 19.
